(19) Europäisches Patentamt / European Patent Office / Office européen des brevets

(11) **EP 4 624 638 A1**

(12) **EUROPEAN PATENT APPLICATION**
published in accordance with Art. 153(4) EPC

(43) Date of publication:
**01.10.2025 Bulletin 2025/40**

(21) Application number: **23899747.2**

(22) Date of filing: **20.11.2023**

(51) International Patent Classification (IPC):
*C30B 15/04* (2006.01)    *C30B 15/20* (2006.01)
*C30B 29/06* (2006.01)    *F04B 41/06* (2006.01)

(52) Cooperative Patent Classification (CPC):
**C30B 15/04; C30B 15/20; C30B 29/06; F04B 41/06**

(86) International application number:
**PCT/CN2023/132728**

(87) International publication number:
**WO 2024/120168 (13.06.2024 Gazette 2024/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 06.12.2022  CN 202211554712
06.12.2022  CN 202211561051
06.12.2022  CN 202223271147 U
14.04.2023  CN 202320847320 U

(71) Applicant: **Longi Green Energy Technology Co.,
Ltd.**
**Xi'an, Shaanxi 710100 (CN)**

(72) Inventors:
• **XIE, Zhiyan**
  **Shaanxi 710100 (CN)**
• **MA, Xiaokang**
  **Shaanxi 710100 (CN)**
• **DENG, Hao**
  **Shaanxi 710100 (CN)**
• **LI, Qiao**
  **Shaanxi 710100 (CN)**
• **DU, Chao**
  **Shaanxi 710100 (CN)**
• **HAN, Wei**
  **Shaanxi 710100 (CN)**

(74) Representative: **Pfenning, Meinig & Partner mbB
Patent- und Rechtsanwälte
Theresienhöhe 11a
80339 München (DE)**

(54) **CRYSTAL GROWING METHOD, SINGLE CRYSTAL FURNACE VACUUM SYSTEM AND CZOCHRALSKI GROWTH DEVICE**

(57)    The present application discloses a crystal growth method, a single crystal furnace vacuum system, and a Czochralski crystal growth device. The method includes: performing leakage detection on a single crystal furnace in an environment at a first furnace pressure; adding a dopant into the single crystal furnace in an environment at a second furnace pressure, where the second furnace pressure is greater than the first furnace pressure; and performing a crystal pulling process after the dopant is added. The present application can reduce differences in axial concentration distribution of a doping element in doped monocrystalline silicon, improve the uniformity of axial resistivity of the monocrystalline silicon, and also improve production efficiency.

FIG. 1

## Description

The present application claims priorities to Chinese Patent Application No. 202211554712.9, entitled "CRYSTAL GROWTH METHOD AND CRYSTALLINE SILICON" and filed with the China National Intellectual Property Administration on December 06, 2022, Chinese Patent Application No. 202211561051.2, entitled "CRYSTAL GROWTH METHOD AND CRYSTALLINE SILICON" and filed with the China National Intellectual Property Administration on December 06, 2022, Chinese Patent Application No. 202223271147.3, entitled "SINGLE CRYSTAL FURNACE VACUUM SYSTEM AND CZOCHRALSKI CRYSTAL GROWTH DEVICE" and filed with the China National Intellectual Property Administration on December 06, 2022, and Chinese Patent Application No. 202320847320.5, entitled "SINGLE CRYSTAL FURNACE VACUUM SYSTEM AND CZOCHRALSKI CRYSTAL GROWTH DEVICE" and filed with the China National Intellectual Property Administration on April 14, 2023, which are incorporated herein by reference in their entities.

## TECHNICAL FIELD

The present application relates to the field of solar photovoltaic technologies, and in particular, to a crystal growth method, a single crystal furnace vacuum system, and a Czochralski crystal growth device.

## BACKGROUND

At the present stage, monocrystalline silicon is widely applied in the solar photovoltaic industry.

However, the monocrystalline silicon in the solar photovoltaic industry is generally prepared by using the Czochralski method. In the Czochralski method, growth of monocrystalline silicon needs to be completed in a single crystal furnace through a series of processes such as melting of a silicon material, seed dipping, shouldering, shoulder formation, constant-diameter growth, and ending. To change an energy level structure of the silicon and improve semiconductor performance of the silicon, a doping element generally needs to be added when the silicon material is melted, to dope the monocrystalline silicon.

However, in doped monocrystalline silicon prepared by using the existing Czochralski method, a large difference in axial resistivity is easily caused due to a non-uniform distribution of a doping element in a growth process. Consequently, the resistivity of the doped monocrystalline silicon finally obtained through growth cannot satisfy a use requirement of an actual photovoltaic product such as a solar cell.

## SUMMARY

The present application provides a crystal growth method, aiming to improve the uniformity of distribution of a doping element in a doped monocrystalline silicon prepared by using a Czochralski method, and reduce a difference in axial resistivity.

According to a first aspect, an embodiment of the present application provides a crystal growth method, including:

performing leakage detection on a single crystal furnace in an environment at a first furnace pressure;
adding a dopant into the single crystal furnace in an environment at a second furnace pressure, where the second furnace pressure is greater than the first furnace pressure; and
performing a crystal pulling process after the dopant is added.

In an embodiment, in the crystal growth method, the first furnace pressure is less than 1 Torr.

In an embodiment, in the crystal growth method, the second furnace pressure is greater than 60 Torr.

In an embodiment, in the crystal growth method, the adding a dopant into the single crystal furnace in an environment at a second furnace pressure includes:

adding a silicon material and the dopant into the single crystal furnace in the environment at the second furnace pressure;
or
adding a silicon material into the single crystal furnace in the environment at the first furnace pressure; and
adding the dopant into the single crystal furnace in the environment at the second furnace pressure after the silicon material is melted.

In an embodiment, in the crystal growth method, the performing a crystal pulling process includes:
performing Czochralski crystal growth by lowering a crystal pulling furnace pressure from the second furnace pressure at a constant-diameter growth stage according to an actual constant-diameter growth length of doped monocrystalline silicon.

In an embodiment, in the crystal growth method, the performing Czochralski crystal growth by lowering a crystal pulling furnace pressure from the second furnace pressure according to an actual constant-diameter growth length of doped monocrystalline silicon includes:
controlling a crystal pulling furnace pressure at an initial phase of constant-diameter growth to be within a range of 80 to 300 Torr; and controlling a crystal pulling furnace pressure at a final phase of constant-diameter growth to be less than 100 mTorr.

In an embodiment, in the crystal growth method, an argon flow rate at the initial phase of constant-diameter growth is greater than 200 L/min; and an argon flow rate at the final phase of the constant-diameter growth is less than 5 L/min.

In an embodiment, in the crystal growth method, an argon flow rate of the material melting operation ranges from 50 to 100 L/min, and argon flow rates of operations of addition of the dopant and temperature adjustment and operations of seed dipping, shouldering, and shoulder formation range from 100 to 300 L/min.

In an embodiment, in the crystal growth method, before the performing Czochralski crystal growth by lowering a crystal pulling furnace pressure from the second furnace pressure according to an actual constant-diameter growth length of doped monocrystalline silicon, the method further includes:

> determining a first correspondence between crystal pulling furnace pressures and constant-diameter growth lengths of the doped monocrystalline silicon, where in the first correspondence, crystal pulling furnace pressures corresponding to different constant-diameter growth lengths are at least partially different, to cause an axial concentration of a doping element in the doped monocrystalline silicon to tend to be uniform in response to controlling Czochralski crystal growth at the constant-diameter growth stage at a crystal pulling furnace pressure determined according to the first correspondence; and
> the performing Czochralski crystal growth by lowering a crystal pulling furnace pressure from the second furnace pressure according to an actual constant-diameter growth length of doped monocrystalline silicon includes:

>> obtaining the actual constant-diameter growth length of the doped monocrystalline silicon when the doped monocrystalline silicon is at the constant-diameter growth stage;
>> determining a target crystal pulling furnace pressure corresponding to the actual constant-diameter growth length according to the first correspondence between crystal pulling furnace pressures and constant-diameter growth lengths of the doped monocrystalline silicon; and
>> controlling Czochralski crystal growth according to the target crystal pulling furnace pressure.

In an embodiment, in the crystal growth method, in the first correspondence, crystal pulling furnace pressures and constant-diameter growth lengths of the doped monocrystalline silicon are negatively correlated.

In an embodiment, in the crystal growth method, the controlling Czochralski crystal growth according to the target crystal pulling furnace pressure includes:
adjusting crystal pulling process parameters according to the target crystal pulling furnace pressure, where the crystal pulling process parameters include an argon flow rate and a dry pump frequency.

In an embodiment, before the adjusting crystal pulling process parameters according to the target crystal pulling furnace pressure, the method further includes:

> determining a second correspondence among crystal pulling furnace pressures of the doped monocrystalline silicon, argon flow rates, and dry pump frequencies, where in response to controlling Czochralski crystal growth according to an argon flow rate and a dry pump frequency that are determined according to the second correspondence, a crystal pulling furnace pressure of the doped monocrystalline silicon is adjusted to a corresponding pressure value, and a crystal pulling rate of the doped monocrystalline silicon tends to be a maximum value; and
> the adjusting crystal pulling process parameters according to the target crystal pulling furnace pressure includes:

>> determining a target argon flow rate and a target dry pump frequency that correspond to the target crystal pulling furnace pressure according to the second correspondence among crystal pulling furnace pressures of the doped monocrystalline silicon, argon flow rates, and dry pump frequencies; and
>> controlling Czochralski crystal growth according to the target argon flow rate and the target dry pump frequency.
>> In an embodiment, the crystal pulling process parameters further include a heater power and a crystal pulling rate; before the adjusting crystal pulling process parameters according to the target crystal pulling furnace pressure, the method further includes:

>>> determining a third correspondence among crystal pulling furnace pressures of the doped monocrystalline silicon, argon flow rates, dry pump frequencies, heater powers, and crystal pulling rates, where in response to controlling Czochralski crystal growth according to an argon flow rate a dry pump frequency, a heater power, and a crystal pulling rate that are determined according to the third correspondence, a crystal pulling furnace pressure of the doped monocrystalline silicon is adjusted to a corresponding pressure value, and a crystal pulling rate of the doped monocrystalline silicon tends to be a maximum value; and

the adjusting crystal pulling process parameters according to the target crystal pulling furnace pressure includes:

determining a target argon flow rate, a target dry pump frequency, a target heater power, and a target crystal pulling rate that correspond to the target crystal pulling furnace pressure according to the third correspondence among crystal pulling furnace pressures of the doped monocrystalline silicon, argon flow rates, dry pump frequencies, heater powers, and crystal pulling rates; and

controlling Czochralski crystal growth according to the target argon flow rate, the target dry pump frequency, the target heater power, and the target crystal pulling rate.

In an embodiment, in the crystal growth method, in the second correspondence, the crystal pulling furnace pressures are positively correlated with the argon flow rates.

In an embodiment, in the crystal growth method, the performing a crystal pulling process includes:

performing a temperature adjustment operation at a third furnace pressure after completing dopant addition and melting a silicon material, where the third furnace pressure is less than or equal to 3 Torr;

performing operations of seed dipping, shouldering, and shoulder formation at a fourth furnace pressure after temperature adjustment, where the fourth furnace pressure is less than or equal to the third furnace pressure; and

performing constant-diameter growth after shoulder formation, and performing Czochralski crystal growth by lowering a crystal pulling furnace pressure from the fourth furnace pressure at a constant-diameter growth stage according to an actual constant-diameter growth length of doped monocrystalline silicon.

According to a second aspect, an embodiment of the present application provides crystalline silicon, prepared by using the crystal growth method described above.

In this embodiment of the present application, leakage detection is performed on a single crystal furnace in an environment at a first furnace pressure, a dopant is added into the single crystal furnace in an environment at a second furnace pressure, and then, a crystal pulling process may be performed, where the second furnace pressure is greater than the first furnace pressure. Leakage detection is first performed at a low furnace pressure, while the dopant is added at a high furnace pressure, so that the high furnace pressure can be used to prevent the dopant from being volatilized, to ensure stability of the doping amount in the furnace, which can improve uniformity of head resistivity and accuracy of head doping, and can improve a head pulling rate. Therefore, this embodiment of the present application can reduce differences in axial concentration distribution of a doping element in doped monocrystalline silicon, improve the uniformity of axial resistivity of the monocrystalline silicon, and also improve production efficiency.

According to a third aspect, an embodiment of the present application provides a crystal growth method, including:

performing temperature adjustment at a fifth furnace pressure after a silicon material is melted, where the fifth furnace pressure is less than or equal to 3 Torr;

performing seed dipping, shouldering, and shoulder formation at a sixth furnace pressure after temperature adjustment, where the sixth furnace pressure is less than or equal to the fifth furnace pressure; and

performing constant-diameter growth after shoulder formation, and performing Czochralski crystal growth by lowering a crystal pulling furnace pressure from the sixth furnace pressure at a constant-diameter growth stage according to an actual constant-diameter growth length.

In an embodiment, in the crystal growth method, the performing Czochralski crystal growth by lowering a crystal pulling furnace pressure from the sixth furnace pressure according to an actual constant-diameter growth length of monocrystalline silicon includes:

controlling a crystal pulling furnace pressure at the constant-diameter growth stage to be within a range of 1 mTorr to 3 Torr, an argon flow rate to be within a range of 50 to 200 L/min, and a dry pump frequency to be within a range of 30 to 55 Hz.

In an embodiment, in the crystal growth method, the performing Czochralski crystal growth by lowering a crystal pulling furnace pressure from the sixth furnace pressure according to an actual constant-diameter growth length of monocrystalline silicon includes:

controlling a crystal rotation rate to be within a range of 5 to 11 RPM and a crucible rotation rate to be within a range of 4 to 9 RPM.

In an embodiment, in the crystal growth method, the performing Czochralski crystal growth by lowering a crystal pulling furnace pressure from the sixth furnace pressure according to an actual constant-diameter growth length includes: controlling, in response to increasing the actual constant-diameter growth length from zero to less than or equal to 5% of a total length of a constant-diameter part, a furnace pressure to be within a range of 0.3 to 3 Torr, an argon flow rate to be within a range of 15 L/min to 50 L/min, and a heating power to decrease by 2.5 Kw. In an embodiment, the furnace pressure may be 0.3 Torr, 0.5 Torr, 1 Torr, 2 Torr, or the like.

In an embodiment, in the crystal growth method, the performing Czochralski crystal growth by lowering a crystal pulling furnace pressure from the sixth furnace pressure according to an actual constant-diameter growth length includes: controlling a pulling rate to be within a range of 75 mm/hr to 120 mm/hr and a crucible rotation rate to be within a range of 5 RPM to 6 RPM.

In an embodiment, in the crystal growth method, the performing Czochralski crystal growth by lowering a crystal pulling furnace pressure from the sixth furnace pressure according to an actual constant-diameter growth length further includes:
controlling, in response to increasing the actual constant-diameter growth length from 5% of a total length of a constant-diameter part to less than or equal to 10% of the total length of the constant-diameter part, a furnace pressure to be within a range of 5 mTorr to 0.3 Torr and an argon flow rate to be within a range of 5 L/min to 15 L/min.

In an embodiment, in the crystal growth method, the performing Czochralski crystal growth by lowering a crystal pulling furnace pressure from the sixth furnace pressure according to an actual constant-diameter growth length includes: controlling, in response to increasing the actual constant-diameter growth length from 10% of a total length of a constant-diameter part to less than or equal to 55% of the total length of the constant-diameter part, a furnace pressure to be not greater than 5 mTorr and an argon flow rate to be not less than 5 L/min.

In an embodiment, in the crystal growth method, the performing Czochralski crystal growth by lowering a crystal pulling furnace pressure from the sixth furnace pressure according to an actual constant-diameter growth length includes: controlling, in response to increasing the actual constant-diameter growth length from 55% of a total length of a constant-diameter part to less than or equal to 100% of the total length of the constant-diameter part, a furnace pressure to be within a range of 1 mTorr to 5 mTorr, an argon flow rate to be 5 L/min, and a dry pump frequency to be 55 Hz.

In an embodiment, in the crystal growth method, during the performing Czochralski crystal growth by lowering a crystal pulling furnace pressure from the sixth furnace pressure, a pulling rate increment $\Delta V$ and a power increment $\Delta P$ satisfy $\Delta V = -K * \Delta P$, where K ranges from 0.06 to 0. 11.

In an embodiment, in the crystal growth method, a furnace pressure P of a single crystal furnace, a dry pump quantity n, a dry pump frequency f, and an argon flow rate Q satisfy the following relational expression:

$$P = A/(n * f) - B/Q + C$$

where A ranges from 1 to 120, B ranges from 1 to 100, C ranges from 0 to 0.05, and $Q \geq 1$ L/min.

According to a fourth aspect, an embodiment of the present application provides doped monocrystalline silicon, prepared by using the crystal growth method described above, where an oxygen content of the crystalline silicon is less than or equal to 11 ppma.

In this embodiment of the present application, temperature adjustment is performed at a fifth furnace pressure after the silicon material is melted, where the fifth furnace pressure is less than or equal to 3 Torr; operations of seed dipping, shouldering, and shoulder formation are performed at a sixth furnace pressure less than or equal to the fifth furnace pressure after temperature adjustment; and constant-diameter growth is performed after shoulder formation, and Czochralski crystal growth performed by lowering a crystal pulling furnace pressure from the sixth furnace pressure at a constant-diameter growth stage according to an actual constant-diameter growth length of the doped monocrystalline silicon. In the operations of temperature adjustment, seed dipping, shouldering, and shoulder formation, a low furnace pressure less than or equal to 3 Torr is used, so that under stable seed dipping-shouldering quality, a low furnace pressure state of constant-diameter growth can be quickly reached. Moreover, the crystal pulling furnace pressure is continuously reduced as the constant-diameter growth length increases, so that the dopant can be prevented from being volatilized at an early stage of constant-diameter growth, to ensure stability of the doping amount in the furnace, which not only can improve uniformity of head resistivity and accuracy of head doping, but also can improve a head pulling rate. In addition, at middle and late stages of constant-diameter growth, use of a lower furnace pressure can promote volatilization of the dopant at the middle and late stages of constant-diameter growth, thereby improving the tail resistivity, and increasing the constant-diameter length of the crystal. Therefore, this embodiment of the present application can reduce differences in axial concentration distribution of a doping element in doped monocrystalline silicon, improve the uniformity of axial resistivity of the monocrystalline silicon, and also improve production efficiency.

A technical problem to be resolved by the present application is to provide a single crystal furnace vacuum system and a Czochralski crystal growth device, so as to resolve a problem that the length of a crystal rod within an effective range of resistivity cannot be further increased because the furnace pressure cannot be further reduced in the existing single crystal growth process.

To resolve the foregoing problem, the present application is implemented by using the following technical solution:

The present application provides a single crystal furnace vacuum system, including an exhaust pipe group, a filtering apparatus, and a vacuumization apparatus, where

> one end of the exhaust pipe group is in communication with a furnace bottom of a single crystal furnace;
> the other end of the exhaust pipe group is in communication with an air inlet of the filtering apparatus;
> the vacuumization apparatus is in communication with an air outlet of the filtering apparatus by using a vacuum pipeline; and
> the vacuumization apparatus includes a plurality of vacuum pumps, and the plurality of vacuum pumps are connected in series or in parallel by using the vacuum pipeline.

In an embodiment, in the single crystal furnace vacuum system, the plurality of vacuum pumps include a plurality of dry pumps, and the plurality of dry pumps are connected in parallel by using the vacuum pipeline.

In an embodiment, in the single crystal furnace vacuum system, the plurality of vacuum pumps include one molecular pump and one dry pump, and a front end of the molecular pump is in communication with an air outlet of the filtering apparatus by using the vacuum pipeline; and a tail end of the molecular pump is in communication with a front end of the dry pump by using the vacuum pipeline.

In an embodiment, in the single crystal furnace vacuum system, the furnace bottom of the single crystal furnace is provided with an exhaust vent, and the exhaust vent is connected to the other end of the exhaust pipe group.

In an embodiment, in the single crystal furnace vacuum system, at least two exhaust vents are provided, and a ratio of a total area of the exhaust vents to a total area of the furnace bottom is less than 50%.

In an embodiment, in the single crystal furnace vacuum system, the exhaust vents are uniformly distributed along the furnace bottom.

In an embodiment, in the single crystal furnace vacuum system, the exhaust vent is circular or square.

In an embodiment, in the single crystal furnace vacuum system, the exhaust pipe group includes a plurality of exhaust pipelines disposed in parallel, and a front end of each of the exhaust pipelines is connected to the exhaust vent.

In an embodiment, in the single crystal furnace vacuum system, a first throttle valve is disposed on the exhaust pipeline between the exhaust vent and the filtering apparatus.

In an embodiment, in the single crystal furnace vacuum system, the exhaust pipe group further includes a convergence pipeline, tail ends of at least two of the exhaust pipelines are connected to one end of the convergence pipeline, and the other end of the convergence pipeline is connected to the air inlet of the filtering apparatus by using a vacuum ball valve.

In an embodiment, in the single crystal furnace vacuum system, a cross-sectional flow area of the convergence pipeline is greater than a cross-sectional flow area of each of the exhaust pipelines connected to the convergence pipeline.

In an embodiment, in the single crystal furnace vacuum system, a cross-sectional flow area of the convergence pipeline is not less than a sum of cross-sectional flow areas of the exhaust pipelines connected to the convergence pipeline.

In an embodiment, in the single crystal furnace vacuum system, a second throttle valve is disposed on the convergence pipeline.

In an embodiment, in the single crystal furnace vacuum system, the single crystal furnace vacuum system is configured to control, in a case that a given argon flow rate ranges from 1 to 10 L/min in the single crystal furnace, a gas pressure in the furnace to be within a range of 0.5 to 10 Pa.

The present application provides a Czochralski crystal growth device, including a single crystal furnace and the single crystal furnace vacuum system described above.

Compared with the related art, the present application includes the following advantages:

The single crystal furnace vacuum system in the present application includes an exhaust pipe group, a filtering apparatus, and a vacuumization apparatus, where one end of the exhaust pipe group is in communication with a furnace bottom of a single crystal furnace; the other end of the exhaust pipe group is in communication with an air inlet of the filtering apparatus; the vacuumization apparatus is in communication with an air outlet of the filtering apparatus by using a vacuum pipeline; and the vacuumization apparatus includes a plurality of vacuum pumps, and the plurality of vacuum pumps are connected in series or in parallel by using the vacuum pipeline. The plurality of vacuum pumps are connected in series or in parallel by using the vacuum pipeline to form the vacuumization apparatus, so that vacuumization performance of the vacuumization apparatus can be improved without changing performance of the vacuum pump, to achieve a low furnace pressure effect, thereby increasing volatilization of a doping element at a late stage of constant-diameter growth, and effectively reducing a resistivity attenuation rate of the crystal rod.

## BRIEF DESCRIPTION OF THE DRAWINGS

To describe the technical solutions in the embodiments of the present application more clearly, the following briefly introduces the accompanying drawings required for describing the embodiments of the present application. Apparently, the accompanying drawings in the following description show only some embodiments of the present application, and a person of ordinary skill in the art may still derive other accompanying drawings from these accompanying drawings without creative efforts.

FIG. 1 is a flowchart of steps of a crystal growth method according to embodiment one of the present application;
FIG. 2 is a flowchart of steps of a crystal growth method according to embodiment two of the present application;
FIG. 3 is a flowchart of steps of a crystal growth method according to embodiment three of the present application;
FIG. 4 is a flowchart of steps of a crystal growth method according to embodiment four of the present application;
FIG. 5 is a schematic diagram of comparison between average growth pulling rates of monocrystalline silicon rods prepared by using Embodiment 1 of the present application and a conventional process;
FIG. 6 is a schematic diagram of head resistance hit ratios of a doped monocrystalline silicon rod grown by using Embodiment 1 of the present application and a monocrystalline silicon rod prepared by using a conventional Czochralski method;
FIG. 7 is a flowchart of steps of a crystal growth method according to embodiment four of the present application;
FIG. 8 is a flowchart of steps of a crystal growth method according to embodiment five of the present application;
FIG. 9 is a schematic diagram of rod lengths of a doped monocrystalline silicon rod grown by using Embodiment 2 of the present application and a monocrystalline silicon rod prepared by using an existing Czochralski method;
FIG. 10 is a schematic diagram of resistance distributions of a doped monocrystalline silicon rod grown by using Embodiment 2 of the present application and a monocrystalline silicon rod prepared by using an existing Czochralski method;
FIG. 11 is a schematic structural diagram of a single crystal furnace vacuum system according to a first embodiment of the present application;
FIG. 12 is a schematic structural diagram of a single crystal furnace vacuum system according to a second embodiment of the present application;
FIG. 13 is a schematic structural diagram of a single crystal furnace vacuum system according to a third embodiment of the present application;
FIG. 14 is a schematic structural diagram of a single crystal furnace vacuum system according to a fourth embodiment of the present application;
FIG. 15 is a schematic structural diagram of a single crystal furnace vacuum system according to a fifth embodiment of the present application;
FIG. 16 is a schematic diagram of control logic of a single crystal furnace vacuum system according to an embodiment of the present application; and

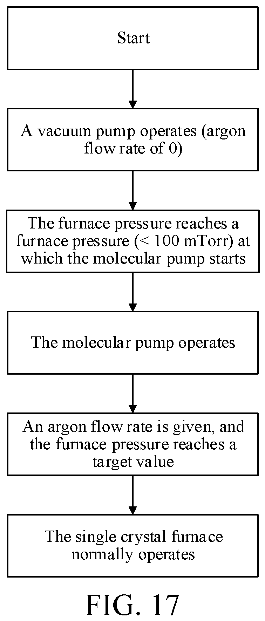

FIG. 17 is a schematic diagram of control logic of a single crystal furnace vacuum system according to another embodiment of the present application.

## DETAILED DESCRIPTION

The following clearly and completely describes the technical solutions in the embodiments of the present application with reference to the accompanying drawings in the embodiments of the present application. Apparently, the described embodiments are some of the embodiments of the present application rather than all of the embodiments. All other embodiments obtained by a person of ordinary skill in the art based on the embodiments of the present application without creative efforts shall fall within the protection scope of the present application.

Before the embodiments of the present application are described in detail, an application scenario of the embodiments of the present application is first described.

In an existing Czochralski single crystal growth method, an argon atmosphere is generally used for decompressing crystal pulling, argon is introduced in combination with suction of a vacuum pump, and a flowing argon atmosphere at a reduced pressure approximately ranging from 10 to 20 Torr is formed, and is kept unchanged in the entire crystal pulling process.

Under such a condition of a high furnace pressure, it can be known according to a vacuum evaporation purification principle and a segregation principle that the dopant in the furnace and most impurity elements in a silicon material cannot be volatilized. As a result, in a crystal pulling process, the tail resistivity of the crystal rod attenuates as the length of the crystal rod increases. Consequently, the axial resistivity of the grown crystal rod greatly differs, and the length of the crystal rod within the effective range of the resistivity is limited. In addition, because a head resistance hit ratio of a crystal is poor, tail resistivity attenuation is fast, and an effective rod length is small, a yield of a single furnace is low, and comprehensive crystal pulling costs are high.

Based on the foregoing problem, an embodiment of the present application provides a crystal growth method, aiming to improve the uniformity of distribution of a doping element in a doped monocrystalline silicon prepared by using a Czochralski method, reduce a difference in axial resistivity, and avoid the problem that in the doped monocrystalline silicon prepared by using the Czochralski method, an excessively large difference in axial resistivity is caused due to a non-uniform distribution of a doping element in a growth process. Consequently, the resistivity of the doped monocrystalline silicon finally obtained through growth cannot satisfy a use requirement of an actual photovoltaic product such as a solar cell.

**Embodiment one**

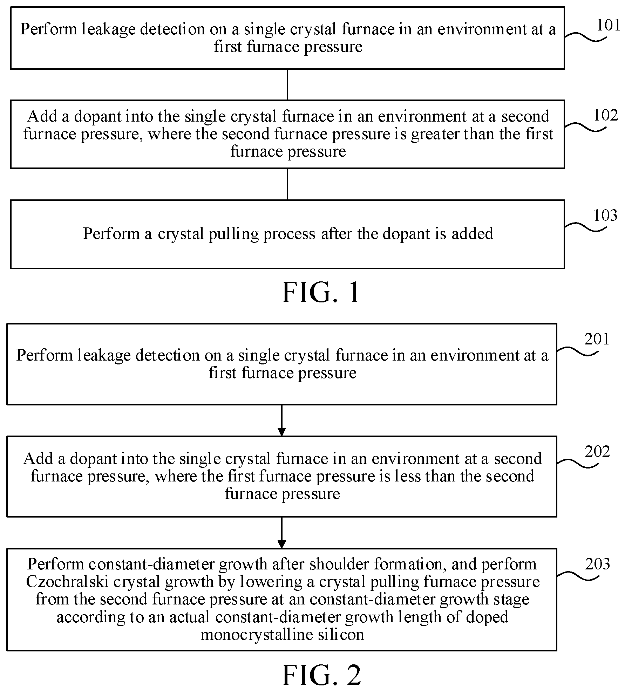

Referring to FIG. 1, FIG. 1 is a flowchart of steps of a crystal growth method according to embodiment one of the present application. The method is applied to a Czochralski growth process of doped monocrystalline silicon, and the method may include step 101 to step 103.

Step 101: Add a silicon material into a single crystal furnace in an environment at a first furnace pressure.

In this step, first, vacuumization and leakage detection are performed on the single crystal furnace. Specifically, the single crystal furnace is vacuumized to the first furnace pressure. The first furnace pressure is a small furnace pressure value, which can ensure that the single crystal furnace can bear a furnace pressure environment in a subsequent crystal pulling process.

In an embodiment, the first furnace pressure is less than 1 Torr. For example, the first furnace pressure is 0.7 Torr, 0.8 Torr, or 0.9 Torr.

Step 102: Add a dopant into the single crystal furnace in an environment at a second furnace pressure, where the first furnace pressure is less than the second furnace pressure.

In this step, after melting of the silicon material is completed, or when the silicon material is added, the dopant is added to the furnace, and the furnace pressure in the foregoing process is controlled to be in a state of the second furnace pressure. The foregoing dopant may be phosphorus, arsenic, boron, gallium, or the like.

The second furnace pressure is a large furnace pressure value, so that volatilization of the dopant can be prevented by using the high furnace pressure and stability of a doping amount in the furnace can be ensured.

In an embodiment, the second furnace pressure is greater than 60 Torr, and may range from 60 to 300 Torr. For example, the second furnace pressure is 60 Torr, 100 Torr, or 300 Torr.

In an embodiment, in a process of adding the dopant, the argon flow rate is controlled to be within a range of 100 to 300 L/min, for example, 100 L/min, 200 L/min, or 300 L/min.

In an embodiment, step 102 includes step 1021 or step 1022 to step 1023.

Step 1021: Add a silicon material and the dopant into the single crystal furnace in the environment at the second furnace pressure.

In this embodiment, the silicon material and the dopant are both added to the single crystal furnace, and the furnace pressure in the foregoing process is controlled to be in the state of the second furnace pressure, so that the process time and the feeding time can be reduced.

In another embodiment, step 102 includes step 1022 to step 1023.

Step 1022: Add a silicon material into the single crystal furnace in the environment at the first furnace pressure.

In this step, after vacuumization and leakage detection on the single crystal furnace are completed, the silicon material starts to be added to the furnace, and then the melted material is heated, to control the furnace pressure in the process to be in the state of the first furnace pressure.

The first furnace pressure is a small furnace pressure value, so that the low furnace pressure can be used to increase volatilization of impurities in the furnace and improve the purity of the melted silicon.

In an embodiment, an argon flow rate of the material melting operation ranges from 50 to 100 L/min, so that an environment with a high argon flow rate and a low furnace pressure less than 1 Torr can be created within a performance range of an existing dry pump, and volatilization and removal of impurities in the furnace can be accelerated by using the environment with a high argon flow rate and a low furnace pressure, thereby further improving the purity of the melted silicon. The argon flow rate of the melting operation may be specifically 50 L/min, 80 L/min, or 100 L/min.

Step 1023: Add the dopant into the single crystal furnace in the environment at the second furnace pressure after the silicon material is melted.

In this step, after addition of the silicon material is completed, or melting of the silicon material is completed, the dopant is added to the furnace, and the furnace pressure in the foregoing process is controlled to be in a state of the second furnace pressure.

In this embodiment, the addition of the silicon material and the melting are first performed at a low furnace pressure less than 1 Torr, so that volatilization of impurities in the furnace can be increased, and the purity of the melted silicon can be improved; and when the dopant is added, a high furnace pressure greater than 60 Torr is used, so that the high furnace pressure can be used to prevent the dopant from being volatilized, to ensure stability of the doping amount in the furnace, which can improve uniformity of head resistivity and accuracy of head doping.

In an embodiment, in operations of addition of the dopant and temperature adjustment and operations of seed dipping, shouldering, and shoulder formation, the argon flow rate is controlled to be within a range of 100 to 300 L/min, for example, 100 L/min, 200 L/min, or 300 L/min.

Step 103: Perform a crystal pulling process after the dopant is added.

In this step, after the silicon material and the dopant are completely melted, operations of temperature adjustment, seed dipping, shouldering, shoulder formation, and constant-diameter growth are sequentially performed.

In this embodiment of the present application, leakage detection is performed on the single crystal furnace in the environment of the first furnace pressure, and the dopant is added to the single crystal furnace in the environment of the second furnace pressure, and then the crystal pulling process may be performed, where the second furnace pressure is greater than the first furnace pressure. Leakage detection is first performed at a low furnace pressure, while the dopant is added at a high furnace pressure, so that the high furnace pressure can be used to prevent the dopant from being volatilized, to ensure stability of the doping amount in the furnace, which can improve uniformity of head resistivity and accuracy of head doping. In addition, due to the high furnace pressure, a large flow of the introduced argon can take away latent heat of crystallization from growth of the crystal rod, thereby increasing a pulling rate. Therefore, this embodiment of the present application can reduce differences in axial concentration distribution of a doping element in doped monocrystalline silicon, improve the uniformity of axial resistivity of the monocrystalline silicon, and also improve production efficiency.

An embodiment of the present application further provides crystalline silicon, prepared by using the crystal growth method described above.

When the foregoing crystalline silicon is prepared, leakage detection is performed on the single crystal furnace in the environment of the first furnace pressure, and the dopant is added to the single crystal furnace in the environment of the second furnace pressure, and then the crystal pulling process may be performed, where the second furnace pressure is greater than the first furnace pressure. Leakage detection is first performed at a low furnace pressure, while the dopant is added at a high furnace pressure, so that the high furnace pressure can be used to prevent the dopant from being volatilized, to ensure stability of the doping amount in the furnace, which can improve uniformity of head resistivity and accuracy of head doping. In addition, due to the high furnace pressure, a large flow of the introduced argon can take away latent heat of crystallization from growth of the crystal rod, thereby increasing a pulling rate, and reducing differences in axial concentration distribution of a doping element in doped monocrystalline silicon, so that the uniformity of axial resistivity of the doped monocrystalline silicon is higher.

**Embodiment two**

Referring to FIG. 2, FIG. 2 is a flowchart of steps of a crystal growth method according to embodiment two of the present application. The method may include step 201 to step 205:

Step 201: Perform leakage detection on a single crystal furnace in an environment at a first furnace pressure.
For details of this step, refer to the foregoing step 101, and details are not described herein again.
Step 202: Add a dopant into the single crystal furnace in an environment at a second furnace pressure, where the first furnace pressure is less than the second furnace pressure.
For details of this step, refer to the foregoing step 102, and details are not described herein again.
Step 203: Perform constant-diameter growth after shoulder formation, and perform Czochralski crystal growth by lowering a crystal pulling furnace pressure from the second furnace pressure at a constant-diameter growth stage according to an actual constant-diameter growth length of doped monocrystalline silicon.

In this step, operations of temperature adjustment, seed dipping, shouldering, and shoulder formation are performed after the dopant is added, and the furnace pressure during the operations of temperature adjustment, seed dipping, shouldering, and shoulder formation in the Czochralski crystal process is controlled to be in a state of the second furnace pressure; and then constant-diameter growth is performed after shoulder formation, and Czochralski crystal growth is performed by lowering a crystal pulling furnace pressure from the second furnace pressure at a constant-diameter growth stage according to an actual constant-diameter growth length of doped monocrystalline silicon.

In this step, since the doped monocrystalline silicon enters the constant-diameter growth stage, the constant-diameter growth length of the doped monocrystalline silicon is continuously monitored and obtained, and is used as the foregoing actual constant-diameter growth length.

In this step, as the actual constant-diameter growth length increases, the furnace pressure is gradually reduced from the second furnace pressure to control Czochralski crystal growth. That is, a high furnace pressure is used in an early stage of the constant-diameter growth, and a low furnace pressure is used at a late stage of the constant-diameter growth.

In a growth process of a silicon crystal, impurities continuously accumulate in the melt, so that an impurity concentration in the melt is increasingly high, an impurity concentration at the tail of the crystal is also increasingly high, and resistivity is increasingly high. A smaller segregation coefficient indicates a larger head-to-tail resistance ratio.

It can be known according to the segregation principle that the high furnace pressure can suppress volatilization of a doping element in a local high-temperature state in the furnace, thereby improving accuracy and uniformity of a resistance hit ratio. Therefore, in a crystal pulling process, at seed dipping, shouldering, shoulder formation, and the constant-diameter head, the accuracy of the head resistance hit ratio of the crystal can be improved through crystal pulling at a high furnace pressure.

It can be known according to a vacuum evaporation purification principle that, a low furnace pressure can promote volatilization of a doping element, thereby improving the resistivity of the crystal. Therefore, at middle and late stages of constant-diameter growth, crystal pulling at a low furnace pressure can promote volatilization of the doping element and other impurities, thereby improving the resistivity at the tail of the crystal, improving the quality of a silicon wafer, and further improving the conversion efficiency of a cell.

In an embodiment, the performing Czochralski crystal growth by lowering a crystal pulling furnace pressure from the second furnace pressure according to an actual constant-diameter growth length of doped monocrystalline silicon includes:

controlling a crystal pulling furnace pressure at an initial phase of constant-diameter growth to be within a range of 80 to 300 Torr; and controlling a crystal pulling furnace pressure at a final phase of constant-diameter growth to be less than 100 mTorr.

In this embodiment, a crystal pulling process at a high furnace pressure ranging from 80 to 300 Torr is used at the initial phase of constant-diameter growth, thereby reducing volatilization of the dopant and improving accuracy of a head resistance hit ratio; while a low-furnace-pressure crystal pulling process at a crystal pulling furnace pressure less than 100 mTorr is used at the final phase of constant-diameter growth, which can greatly improve the volatilization of the dopant, thereby improving the tail resistivity. In addition, the low furnace pressure can reduce constant-diameter power and improve the power consumption of the furnace.

In a specific embodiment, the initial phase of constant-diameter growth refers to a constant-diameter growth stage at which the actual constant-diameter growth length is less than 10% of the total length of the constant-diameter part, and the final phase of constant-diameter growth refers to a constant-diameter growth stage at which the actual constant-diameter growth length is greater than or equal to 50% of the total length of the constant-diameter part.

In an embodiment, an argon flow rate at the initial phase of constant-diameter growth is set to be within a range of 200 to 300 L/min; and an argon flow rate at the final phase of the constant-diameter growth is less than 5 L/min.

In this embodiment, high-furnace-pressure crystal pulling and a large argon flow rate are used at the constant-diameter head, so that not only accuracy of a resistance hit ratio of the head can be improved, but also heat can be rapidly taken away by using the large argon flow rate, thereby greatly improving a pulling rate in first 50% of constant-diameter growth.

In this embodiment of the present application, the addition of the silicon material and the melting are first performed at a low furnace pressure less than 1 Torr, so that volatilization of impurities in the furnace can be increased, and the purity of the melted silicon can be improved; and in the operations of addition of the dopant, temperature adjustment, seed dipping, shouldering, and shoulder formation and at an early stage of constant-diameter growth, a high furnace pressure greater than 60 Torr is used, so that the high furnace pressure can be used to prevent the dopant from being volatilized, to ensure stability of the doping amount in the furnace, which can improve uniformity of head resistivity and accuracy of head doping. In addition, due to the high furnace pressure, a large flow of the introduced argon can take away latent heat of crystallization from growth of the crystal rod, thereby increasing a head pulling rate. In addition, at middle and late stages of constant-diameter growth, use of a low furnace pressure can promote volatilization of the dopant at the middle and late stages of constant-diameter growth, thereby improving the tail resistivity, and increasing the constant-diameter length of the crystal. Therefore, this embodiment of the present application can reduce differences in axial concentration distribution of a doping element in doped monocrystalline silicon, improve the uniformity of axial resistivity of the monocrystalline silicon, and also improve production efficiency.

During actual application, in the crystal growth method provided in the present application, specific steps are as follows:

After vacuumization on the single crystal furnace is completed, a silicon material is added to the furnace, and the melted material is heated by using a heater, where an argon flow rate in a process of melting the material is set to be within a range of 50 to 100 L/min, and a furnace pressure is maintained to be less than 1 Torr, so as to increase volatilization of impurities in the furnace by using a low furnace pressure and improve purity of the melted silicon; after the addition and melting of the silicon material in the furnace are completed, a dopant is added to the furnace, where the argon flow rate is set to be within a range of 100 to 300 L/min, and the pressure in the furnace is increased to be within a range of 60 to 100 Torr, so as to prevent the dopant from being volatilized by using the high furnace pressure, thereby ensuring the stability of the doping amount in the furnace;

after the silicon material and the dopant are completely melted, temperature adjustment, seed dipping, and shouldering are started, where the pressure in the furnace is maintained to be within a range of 60 to 100 Torr;

after the temperature adjustment, seed dipping, and shouldering are completed, a constant-diameter growth stage is entered, and at an early stage of the constant-diameter growth, a furnace pressure is controlled to be within a range of 80 to 100 Torr, and an argon flow rate is set to be within a range of 200 to 300 L/min, so as to improve uniformity of head resistivity and accuracy of head doping in an environment at a high furnace pressure, and take away more heat by using a large argon flow rate, thereby improving a head pulling rate; and

as the constant-diameter growth length increases, the furnace pressure is controlled to gradually decrease, and after the constant-diameter growth length reaches 50% of the total length of the constant-diameter part, the furnace pressure is controlled to decrease to be less than 100 mTorr, and the argon flow rate is controlled to decrease to be less than 5 L/min, so as to promote, by using a low furnace pressure, acceleration of volatilization of the dopant in the furnace at middle and late stages of constant-diameter growth, improve the tail resistivity, and increase the constant-diameter length of the crystal.

That is, in this embodiment of the present application, in processes of vacuumization and leakage detection, feeding, melting, seed dipping and shouldering, constant-diameter growth, and ending of the single crystal furnace, the head-to-tail resistivity of the crystal is improved by using different changes of the furnace pressure, so that the uniformity of the resistivity is improved without affecting the growth rate of the crystal, thereby improving the production efficiency.

An embodiment of the present application further provides doped monocrystalline silicon, prepared by using the crystal growth method described above.

When the foregoing doped monocrystalline silicon is prepared, the melting is performed at a furnace pressure less than 1 Torr, so that volatilization of impurities in the furnace can be increased, and the purity of the melted silicon can be improved. In the operations of addition of the dopant, seed dipping, shouldering, and shoulder formation and at an early stage of constant-diameter growth, a high furnace pressure ranging from 60 to 300 Torr is used, so that the high furnace pressure can be used to prevent the dopant from being volatilized, to ensure stability of the doping amount in the furnace. As the Czochralski crystal growth is performed, the furnace pressure is gradually decreased, and the saturated vapor pressure is controlled to constantly change with the constant-diameter growth length. In this way, a high furnace pressure may be used at an early stage of the constant-diameter growth to prevent the dopant from being volatilized, and a low furnace pressure may be used at middle and late stages of the constant-diameter growth to promote volatilization of the doping element in the furnaces, thereby reducing differences in axial concentration distribution of a doping element in doped monocrystalline silicon, so that the uniformity of axial resistivity of the doped monocrystalline silicon is higher.

**Embodiment three**

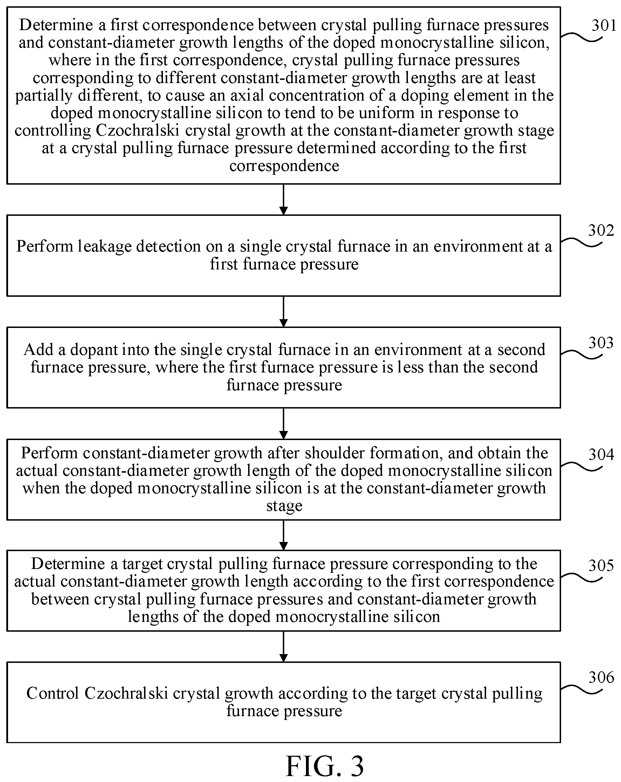

Referring to FIG. 3, FIG. 3 is a flowchart of steps of a crystal growth method according to embodiment three of the present application. The method may include step 301 to step 306:

Step 301: Determine a first correspondence between crystal pulling furnace pressures and constant-diameter growth lengths of the doped monocrystalline silicon, where in the first correspondence, crystal pulling furnace pressures corresponding to different constant-diameter growth lengths are at least partially different, to cause an axial concentration of a doping element in the doped monocrystalline silicon to tend to be uniform in response to controlling Czochralski crystal growth at the constant-diameter growth stage at a crystal pulling furnace pressure determined according to the first correspondence.

In this step, starting from a law that an axial concentration distribution of monocrystalline silicon is non-uniform because a doping element is subject to crystal pulling furnace pressures in different constant-diameter growth lengths, a crystal pulling furnace pressure that can make a saturated vapor pressure of the doping element in the doped monocrystalline silicon at a constant-diameter growth stage constantly change with constant-diameter growth of the monocrystalline silicon to control the axial concentration of the doping element to tend to be uniform is calculated in advance, that is, the foregoing first correspondence is determined.

In an embodiment, in the foregoing first correspondence, crystal pulling furnace pressures and constant-diameter growth lengths of the doped monocrystalline silicon are negatively correlated. That is, in the foregoing first correspondence, the crystal pulling furnace pressure smoothly decreases as the constant-diameter growth length increases, so that when the crystal pulling furnace pressure is adjusted according to the foregoing first correspondence, not only the axial concentration of the doping element can be controlled to tend to be uniform, but also the crystal pulling quality can be further improved.

In an embodiment, in the foregoing first correspondence, crystal pulling furnace pressures and constant-diameter growth lengths of the doped monocrystalline silicon may have a linear negative correlation, a curvilinear negative correlation, or a gradient negative correlation. That is, as the constant-diameter growth length increases, the crystal pulling furnace pressure gradually decreases.

Step 302: Perform leakage detection on a single crystal furnace in an environment at a first furnace pressure.

For details of this step, refer to the foregoing step 101, and details are not described herein again.

Step 303: Add a dopant into the single crystal furnace in an environment at a second furnace pressure, where the first furnace pressure is less than the second furnace pressure.

For details of this step, refer to the foregoing step 102, and details are not described herein again.

Step 304: Perform constant-diameter growth after shoulder formation, and obtain the actual constant-diameter growth length of the doped monocrystalline silicon when the doped monocrystalline silicon is at the constant-diameter growth stage.

In this step, operations of temperature adjustment, seed dipping, shouldering, and shoulder formation are performed after the addition of the dopant is completed, and then since the doped monocrystalline silicon enters the constant-diameter growth stage, the constant-diameter growth length of the doped monocrystalline silicon is continuously monitored and obtained, and is used as the foregoing actual constant-diameter growth length.

Step 305: Determine a target crystal pulling furnace pressure corresponding to the actual constant-diameter growth length according to the first correspondence between crystal pulling furnace pressures and constant-diameter growth lengths of the doped monocrystalline silicon.

In this step, the foregoing first correspondence specifies crystal pulling furnace pressures corresponding to different constant-diameter growth lengths. Therefore, after an actual constant-diameter growth length is obtained, a crystal pulling furnace pressure corresponding to the actual constant-diameter growth length, that is, the foregoing target crystal pulling furnace pressure may be determined.

Step 306: Control Czochralski crystal growth according to the target crystal pulling furnace pressure.

In this step, in response to controlling Czochralski crystal growth at the constant-diameter growth stage at the crystal pulling furnace pressure determined according to the first correspondence, the saturated vapor pressure of the doping element in the doped monocrystalline silicon constantly changes, to make the axial concentration of the doping element tend to be uniform. Therefore, in response to controlling Czochralski crystal growth according to the target crystal pulling process parameter, a difference in concentration distribution of the doping element in the monocrystalline silicon is small, and the axial resistivity of the silicon crystal becomes uniform.

In an embodiment, step 306 specifically includes step 361:

Step 361: Adjust crystal pulling process parameters according to the target crystal pulling furnace pressure, where the crystal pulling process parameters include an argon flow rate and a dry pump frequency.

In this embodiment, because a high argon flow rate can take away more heat, a crystal pulling rate of the monocrystalline silicon is improved. However, due to a limitation on performance of a dry pump, when the dry pump reaches a frequency upper limit, the crystal pulling furnace pressure can be continuously reduced only by reducing the argon flow rate. Therefore, by adjusting the argon flow rate and the dry pump frequency, a required crystal pulling furnace pressure can be achieved within a performance range of the dry pump.

In a specific embodiment, before step 306, step 3610 is further included, and step 361 includes step 3611 to step 3612.

Step 3610: Determine a second correspondence among crystal pulling furnace pressures of the doped monocrystalline silicon, argon flow rates, and dry pump frequencies, where in response to controlling Czochralski crystal growth according to an argon flow rate and a dry pump frequency that are determined according to the second correspondence, a crystal pulling furnace pressure of the doped monocrystalline silicon is adjusted to a corresponding pressure value, and a crystal pulling rate of the doped monocrystalline silicon tends to be a maximum value.

In this step, a large argon flow rate can take away more heat and can improve a crystal pulling rate. However, when the furnace pressure is not changed, a larger argon flow rate indicates a higher required dry pump frequency, while the dry pump is limited by performance and has a frequency upper limit. That is, when the furnace pressure is not changed, a crystal pulling rate of the monocrystalline silicon is determined by both the argon flow rate and the dry pump frequency. Therefore, starting from a law that a large argon flow rate can take more heat and can improve the crystal pulling rate, a maximum argon flow rate for achieving each crystal pulling furnace pressure within a working frequency range of the dry pump, that is, the foregoing second correspondence is determined with reference to the working performance of the dry pump.

Step 3611: Determine a target argon flow rate and a target dry pump frequency that correspond to the target crystal pulling furnace pressure according to the second correspondence among crystal pulling furnace pressures of the doped monocrystalline silicon, argon flow rates, and dry pump frequencies.

In this step, an argon flow rate and a dry pump frequency at each crystal pulling furnace pressure are determined in the second correspondence. Therefore, when the target crystal pulling furnace pressure is obtained, the corresponding argon flow rate and dry pump frequency, that is, the target argon flow rate and the target dry pump frequency may be determined by using the second correspondence.

Step 3612: Control Czochralski crystal growth according to the target argon flow rate and the target dry pump frequency.

In this step, a maximum argon flow rate for achieving each crystal pulling furnace pressure in a working frequency range of the dry pump is determined in the second correspondence. Therefore, Czochralski crystal growth is controlled at the target argon flow rate and the target dry pump frequency, so that not only a target crystal pulling furnace pressure can be achieved, but also crystal pulling can be performed at a maximum value of the crystal pulling rate, thereby improving an overall crystal pulling rate.

In a specific embodiment, in the foregoing second correspondence, the crystal pulling furnace pressure is positively correlated with the argon flow rate. That is, it is set that as the crystal pulling furnace pressure decreases, the argon flow rate also continuously decreases, thereby effectively improving the head crystal pulling rate of the crystal.

In the foregoing embodiment, when the doped monocrystalline silicon is at the constant-diameter growth stage, a corresponding target crystal pulling furnace pressure is first determined according to an actual constant-diameter growth length, and then a corresponding argon flow rate and dry pump frequency are determined according to the target crystal pulling furnace pressure, to control Czochralski crystal growth. In this way, not only a smoothly lowered target crystal pulling furnace pressure can be achieved, to relieve a difference in axial resistivity of the monocrystalline silicon, but also crystal pulling can be performed at a maximum value of a crystal pulling rate, thereby improving an overall crystal pulling rate.

In another embodiment, the crystal pulling process parameters further include a heater power and a crystal pulling rate. Before step 361, step 3630 is further included, and step 361 includes step 3621 to step 3622.

Step 3630: Determine a third correspondence among crystal pulling furnace pressures of the doped monocrystalline silicon, argon flow rates, dry pump frequencies, heater powers, and crystal pulling rates, where in response to controlling Czochralski crystal growth according to an argon flow rate a dry pump frequency, a heater power, and a crystal pulling rate that are determined according to the third correspondence, a crystal pulling furnace pressure of the doped monocrystalline silicon is adjusted to a corresponding pressure value, and a crystal pulling rate of the doped monocrystalline silicon tends to be a maximum value.

In this step, a large argon flow rate can take away more heat and can improve a crystal pulling rate; and reduction of the heater power can reduce generation of heat, thereby further improving the crystal pulling rate. However, when the furnace pressure is not changed, a larger argon flow rate indicates a higher required dry pump frequency, while the dry pump is limited by performance and has a frequency upper limit. In addition, an excessively low heater power affects a state of melted silicon and crystal pulling quality. That is, when the furnace pressure is not changed, a crystal pulling rate of the monocrystalline silicon is determined by all of the argon flow rate, the dry pump frequency, and the heater power. Therefore, starting from a law that a large argon flow rate can take more heat and a low heater power can improve the crystal pulling rate, a maximum argon flow rate and a minimum heater power for achieving each crystal pulling furnace pressure within a working frequency range of the dry pump, that is, the foregoing third correspondence is determined with reference to the working performance of the dry pump.

Step 3621: Determine a target argon flow rate, a target dry pump frequency, a target heater power, and a target crystal pulling rate that correspond to the target crystal pulling furnace pressure according to the third correspondence among crystal pulling furnace pressures of the doped monocrystalline silicon, argon flow rates, dry pump frequencies, heater powers, and crystal pulling rates.

In this step, an argon flow rate, a dry pump frequency, and a heater power at each crystal pulling furnace pressure are determined in the third correspondence. Therefore, when the target crystal pulling furnace pressure is obtained, the corresponding argon flow rate, dry pump frequency, and heater power, that is, the target argon flow rate, the target dry pump frequency, and the target heater power may be determined by using the third correspondence.

Step 3622: Control Czochralski crystal growth according to the target argon flow rate, the target dry pump frequency, the target heater power, and the target crystal pulling rate.

In this step, a maximum argon flow rate and a minimum heater power for achieving each crystal pulling furnace pressure in a working frequency range of the dry pump is determined in the third correspondence. Therefore, Czochralski crystal growth is controlled at the target argon flow rate, the target dry pump frequency, and the target heater power, so that not only a target crystal pulling furnace pressure can be achieved, but also crystal pulling can be performed at a maximum value of the crystal pulling rate, thereby improving an overall crystal pulling rate.

In the foregoing embodiment, when the doped monocrystalline silicon is at the constant-diameter growth stage, a corresponding target crystal pulling furnace pressure is first determined according to an actual constant-diameter growth length, and then a corresponding argon flow rate, dry pump frequency, heater power, and crystal pulling rate are determined according to the target crystal pulling furnace pressure, to control Czochralski crystal growth. In this way, not only a continuously lowered target crystal pulling furnace pressure can be achieved, to relieve a difference in axial resistivity of the monocrystalline silicon, but also crystal pulling can be performed at a maximum value of a crystal pulling rate, thereby improving an overall crystal pulling rate.

**Embodiment four**

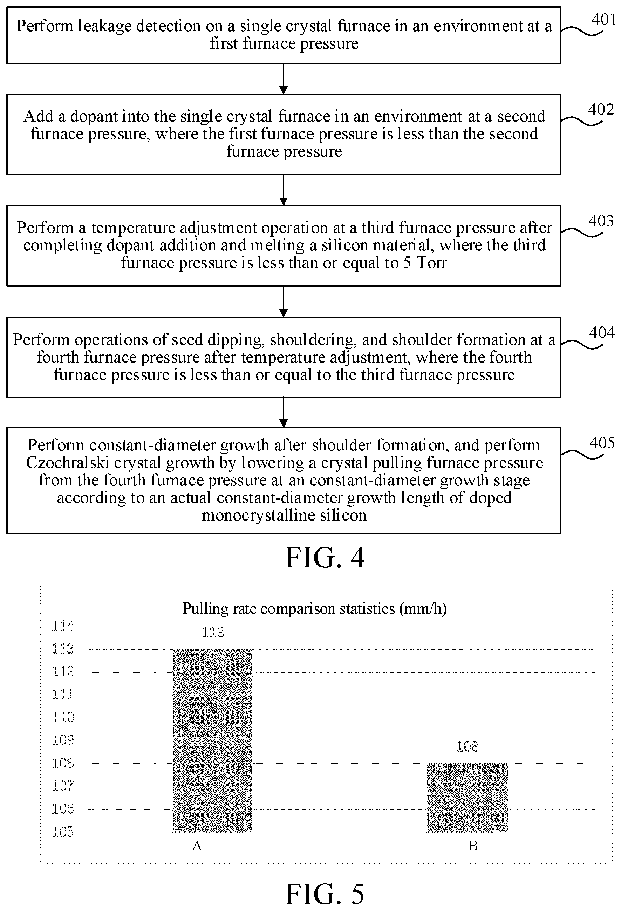

Referring to FIG. 4, FIG. 4 is a flowchart of steps of a crystal growth method according to embodiment four of the present application. The method may include step 401 to step 405:

Step 401: Perform leakage detection on a single crystal furnace in an environment at a first furnace pressure.
For details of this step, refer to the foregoing step 101, and details are not described herein again.
Step 402: Add a dopant into the single crystal furnace in an environment at a second furnace pressure, where the first furnace pressure is less than the second furnace pressure.
For details of this step, refer to the foregoing step 102, and details are not described herein again.
Step 403: Perform a temperature adjustment operation at a third furnace pressure after completing dopant addition and melting a silicon material, where the third furnace pressure is less than or equal to 5 Torr.

In this step, the melting rate of the material lump in the quartz crucible in the single crystal furnace is observed. After the silicon material and the dopant are completely melted, a temperature adjustment operation is completed after seed crystal temperature testing, splicing, and temperature stabilization, to control the furnace pressure in the foregoing process to be in a state of a low furnace pressure less than or equal to 5 Torr.
In an embodiment, in the method provided in the present application, the melting operation is performed at an argon flow rate ranging from 50 to 120 L/min and a furnace pressure less than or equal to 1 Torr, to facilitate acceleration of volatilization and removal of impurities in the furnace at a high argon flow rate and a low furnace pressure, thereby improving the purity of the melted silicon. The argon flow rate in the melting process may be specifically 50 L/min, 100 L/min, or 120 L/min, and the furnace pressure may be specifically 1 Torr or 0.5 Torr.
Step 404: Perform operations of seed dipping, shouldering, and shoulder formation at a fourth furnace pressure after temperature adjustment, where the fourth furnace pressure is less than or equal to the third furnace pressure.
In this step, after the temperature adjustment is completed, operations of seed dipping, shouldering, and shoulder formation are sequentially performed, to control the furnace pressure in each of the foregoing processes to be in the state of the fourth furnace pressure.
The fourth furnace pressure is less than or equal to the third furnace pressure, and the third furnace pressure is less than or equal to 3 Torr, that is, the fourth furnace pressure is also a small furnace pressure value, so that not only a controllable time interval can be provided for the crystallization and the melting of the silicon material, so as to prevent line disconnection and improve a unit yield, but also a target low-furnace-pressure state can be quickly entered at the constant-diameter stage while ensuring seed dipping-shouldering quality.
In an embodiment, argon flow rates of operations of temperature adjustment, seed dipping, shouldering, and shoulder formation range from 50 to 200 L/min.
Step 405: Perform constant-diameter growth after shoulder formation, and perform Czochralski crystal growth by lowering a crystal pulling furnace pressure from the fourth furnace pressure at a constant-diameter growth stage according to an actual constant-diameter growth length of doped monocrystalline silicon.
In this step, since the doped monocrystalline silicon enters the constant-diameter growth stage, the constant-diameter growth length of the doped monocrystalline silicon is continuously monitored and obtained, and is used as the foregoing actual constant-diameter growth length.
In this step, as the actual constant-diameter growth length increases, the furnace pressure is gradually reduced from the fourth furnace pressure to control Czochralski crystal growth. That is, a low furnace pressure is used in an early stage of the constant-diameter growth, and a lower furnace pressure is used at a late stage of the constant-diameter growth.
In a growth process of a silicon crystal, impurities continuously accumulate in the melt, so that an impurity concentration in the melt is increasingly high, an impurity concentration at the tail of the crystal is also increasingly high, and resistivity is increasingly high. A smaller segregation coefficient indicates a larger head-to-tail resistance ratio.
It can be known according to the segregation principle that the high furnace pressure can suppress volatilization of a doping element in a local high-temperature state in the furnace, thereby improving accuracy and uniformity of a resistance hit ratio. Therefore, in a crystal pulling process, at seed dipping, shouldering, shoulder formation, and the constant-diameter head, the accuracy of the head resistance hit ratio of the crystal can be improved through crystal pulling at a relatively high furnace pressure.
In this embodiment of the present application, in the operations of temperature adjustment, seed dipping, shouldering, and shoulder formation, a low furnace pressure less than or equal to 3 Torr is used, so that under stable seed dipping-shouldering quality, a low furnace pressure state of constant-diameter growth can be quickly reached. Moreover, the crystal pulling furnace pressure is continuously reduced as the constant-diameter growth length increases, so that the dopant can be prevented from being volatilized at an early stage of constant-diameter growth, to ensure stability of the doping amount in the furnace, which not only can improve uniformity of head resistivity and accuracy of head doping, but also can improve a head pulling rate. In addition, at middle and late stages of constant-diameter growth, use of a lower furnace pressure can promote volatilization of the dopant at the middle and late stages of constant-diameter growth, thereby improving the tail resistivity, and increasing the constant-diameter length of the crystal. Therefore, this embodiment of the present application can reduce differences in axial concentration distribution of a doping element in doped monocrystalline silicon, improve the uniformity of axial resistivity of the monocrystalline silicon, and also improve production efficiency.

The present application is described in detail below by using examples.

Example 1

(1) After vacuumization on a single crystal furnace is completed, a silicon material is added to the single crystal furnace, and the melted material is heated, where the argon flow rate is set to 80 L/min, the furnace pressure is set to 0.8 Torr, the dry pump frequency is set to 50 Hz, and the heater power is set to 250 Kw.

(2) After the addition and melting of the silicon material in the furnace are completed, a dopant gallium is added to the furnace, where the argon flow rate is set to 80 L/min, the furnace pressure is set to 0.8 Torr, the dry pump frequency is set to 50 Hz, and the heater power is set to 250 Kw.

(3) After the silicon material and the dopant are completely melted, temperature adjustment, seed dipping, and shouldering are started, where the argon flow rate is set to 300 L/min, the furnace pressure is set to 100 Torr, the dry pump frequency is set to 30 Hz, and the heater power is set to 70 Kw.

(4) After the temperature adjustment, seed dipping, and shouldering are completed, a constant-diameter growth stage is entered, and crystal pulling process parameters are adjusted according to the following Table 1, to obtain doped monocrystalline silicon.

Table 1

| Crystal pulling step | | argon flow rate (L/min) | Furnace pressure (Torr) | Dry pump frequency (Hz) | Operating power (Kw) | Pulling rate (mm/hr) |
|---|---|---|---|---|---|---|
| Material melting/feeding | | 80 | 0.8 | 50 | 250 | / |
| Seeding and shouldering | | 300 | 100 | 30 | 70 | / |
| Constant-diameter | 1% | 300 | 100 | 30 | 45 | 86 |
| | 4% | 250 | 70 | 35 | 44 | 90 |
| | 7% | 200 | 50 | 35 | 43 | 95 |
| | 10% | 150 | 25 | 38 | 43 | 100 |
| | 17% | 100 | 11 | 40 | 42 | 110 |
| | 35% | 70 | 6 | 42 | 42 | 120 |
| | 45% | 20 | 0.5 | 46 | 38.5 | 115 |
| | 60% | 4 | 0.1 | 50 | 36 | 108 |
| | 100% | 4 | 0.1 | 50 | 37 | 100 |

Under distribution in a 26-inch thermal field, a monocrystalline silicon rod A is completed by using Embodiment 1 of the present application, and a monocrystalline silicon rod B is prepared by using the existing conventional Czochralski method. Distribution statistics are collected on an average growth pulling rate and a single constant-diameter pull-out ratio of the monocrystalline silicon rod A and the monocrystalline silicon rod B, and results are shown in FIG. 5 and Table 2 respectively.

It can be known from FIG. 5 that because use of a large argon flow rate at the head can take away much heat in the furnace, the single crystal completed in Embodiment 1 of the present application has a pulling rate that is increased by 5 mm/hr relative to that of a single crystal pulled in a conventional process.

Table 2

| Type | Feeding amount (kg) | Resistivity range (Ω•cm) | Single pull-out weight (kg) | Pull-out ratio |
|---|---|---|---|---|
| Example 1 | 330 | 0.4 to 1.1 | 260 | 78.79% |
| Conventional process | | 0.4 to 1.1 | 200 | 60.61% |

It can be known from Table 2 that because use of a low furnace pressure at the tail can promote volatilization of the dopant, the single crystal completed in Embodiment 1 of the present application has a pull-out ratio that can be increased by approximately 18% relative to that of a single crystal pulled in the conventional process.

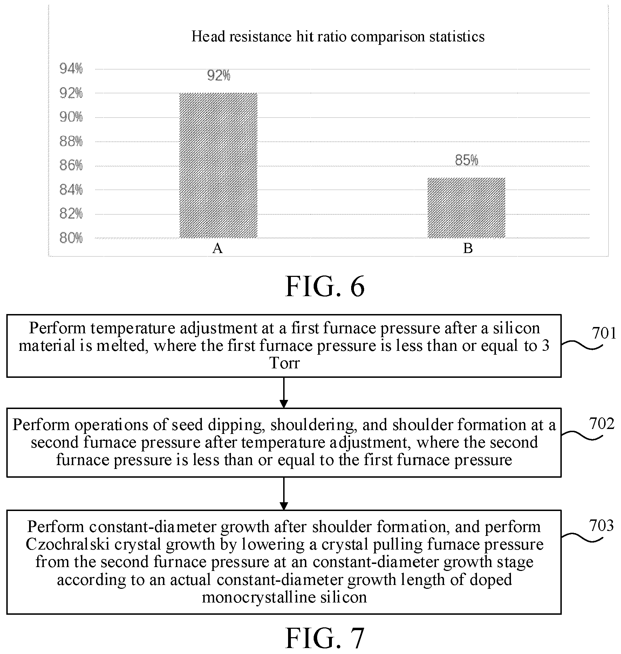

The head of the monocrystalline silicon A and the head of the monocrystalline silicon B that is prepared by using the conventional Czochralski method are sampled, head resistance hit ratios are calculated, and results are shown in FIG. 6.

It can be known from FIG. 6 that because volatilization of the dopant is reduced at the head, the single crystal completed in Embodiment 1 of the present application has accuracy of the head resistance hit ratio that can be increased by more than 7% relative to that of a single crystal pulled in a conventional process.

**Embodiment five**

Referring to FIG. 7, FIG. 7 is a flowchart of steps of a crystal growth method according to embodiment five of the present application. The method is applied to a growth process of doped crystal, and the method may include step 701 to step 703.

Step 701: Perform temperature adjustment at a fifth furnace pressure after a silicon material is melted, where the fifth furnace pressure is less than or equal to 3 Torr.

In this step, the melting rate of the material lump in the quartz crucible in the single crystal furnace is observed. After the silicon material and the dopant are completely melted, a temperature adjustment operation is completed after seed crystal temperature testing, splicing, and temperature stabilization, to control the furnace pressure in the foregoing process to be in a state of a low furnace pressure less than or equal to 3 Torr.

In this embodiment of the present application, the furnace pressure of the melting operation may be greater than the foregoing fifth furnace pressure, or may be less than or equal to the foregoing fifth furnace pressure.

In an embodiment, in the method provided in the present application, the melting operation is performed at an argon flow rate ranging from 50 to 120 L/min and a furnace pressure less than or equal to 1 Torr, to facilitate acceleration of volatilization and removal of impurities in the furnace at a high argon flow rate and a low furnace pressure, thereby improving the purity of the melted silicon. The argon flow rate in the melting process may be specifically 50 L/min, 100 L/min, or 120 L/min, and the furnace pressure may be specifically 1 Torr or 0.5 Torr.

Step 702: Perform operations of seed dipping, shouldering, and shoulder formation at a sixth furnace pressure after temperature adjustment, where the sixth furnace pressure is less than or equal to the fifth furnace pressure.

In this step, after the temperature adjustment is completed, operations of seed dipping, shouldering, and shoulder formation are sequentially performed, to control the furnace pressure in each of the foregoing processes to be in the state of the sixth furnace pressure.

The sixth furnace pressure is less than or equal to the fifth furnace pressure, and the fifth furnace pressure is less than or equal to 3 Torr, that is, the sixth furnace pressure is also a small furnace pressure value, so that a target low-furnace-pressure state can be quickly entered at the constant-diameter stage while ensuring seed dipping-shouldering quality.

In an embodiment, argon flow rates of operations of temperature adjustment, seed dipping, shouldering, and shoulder formation range from 50 to 200 L/min.

Step 703: Perform constant-diameter growth after shoulder formation, and perform Czochralski crystal growth by lowering a crystal pulling furnace pressure from the sixth furnace pressure at a constant-diameter growth stage according to an actual constant-diameter growth length of the doped monocrystalline silicon.

In this step, since the doped monocrystalline silicon enters the constant-diameter growth stage, the constant-diameter growth length of the doped monocrystalline silicon is continuously monitored and obtained, and is used as the foregoing actual constant-diameter growth length.

In this step, as the actual constant-diameter growth length increases, the furnace pressure is gradually reduced from the sixth furnace pressure to control Czochralski crystal growth. That is, a low furnace pressure is used in an early stage of the constant-diameter growth, and a lower furnace pressure is used at middle and late stages of the constant-diameter growth.

In a growth process of a silicon crystal, impurities continuously accumulate in the melt, so that an impurity concentration in the melt is increasingly high, an impurity concentration at the tail of the crystal is also increasingly high, and resistivity is increasingly low. In addition, a smaller segregation coefficient indicates a larger head-tail resistivity difference.

It can be known according to the segregation principle that the high furnace pressure can suppress volatilization of a doping element in a local high-temperature state in the furnace, thereby improving accuracy and uniformity of a resistance hit ratio. Therefore, in a crystal pulling process, at seed dipping, shouldering, shoulder formation, and the constant-diameter head, the accuracy of the head resistance hit ratio of the crystal can be improved through crystal pulling at a relatively high furnace pressure.

The dopant of the Czochralski monocrystalline silicon is mainly an element of Group IIIA or VA. It can be known according to a vacuum evaporation purification principle that, a low furnace pressure can promote volatilization of a doping element, thereby effectively reducing attenuation of the tail resistivity of the crystal and improving the resistivity of the crystal. Therefore, in a crystal pulling process, crystal pulling is performed at the middle and late stages of the constant-diameter growth by using a low-furnace-pressure atmosphere, so that volatilization of the doping element and other metal impurities can be promoted, thereby improving the resistivity distribution of the crystal, and effectively narrowing the resistivity of the monocrystalline silicon rod under a condition of the same pull-out ratio. The effective narrowing of the resistivity helps improve the quality of the monocrystalline silicon wafer end, thereby improving the conversion efficiency of the battery. In addition, because the axial resistivity of the monocrystalline silicon rod is narrowed, the pulling length of the monocrystalline silicon rod can be greatly increased within a same resistivity specification range, helping improve the production efficiency of the single crystal and reduce comprehensive production and preparation costs of the single crystal.

The foregoing doping element may be phosphorus, arsenic, boron, gallium, or the like.

In an embodiment, the performing Czochralski crystal growth by lowering a crystal pulling furnace pressure from the sixth furnace pressure according to an actual constant-diameter growth length of doped monocrystalline silicon includes:

controlling a crystal pulling furnace pressure at the constant-diameter growth stage to be within a range of 1 mTorr to 3 Torr, an argon flow rate to be within a range of 5 to 200 L/min, and a dry pump frequency to be within a range of 30 to 55 Hz.

In this embodiment, the argon flow rate is controlled to be within a range of 5 to 200 L/min and the dry pump frequency is controlled to be within a range of 30 to 55 Hz, so that the crystal pulling furnace pressure ranges from 1 mTorr to 3 Torr, and gradually decreases from the constant-diameter head. Oxygen in the crystal is mainly derived from a high-temperature dissolution reaction of the quartz crucible. The reaction is mainly $SiO_2 + Si = 2SiO$, and a part of SiO generated by the reaction enters the crystal, causing formation of oxygen in the crystal. It can be known according to the principle of vacuum volatilization that, a lower furnace pressure can accelerate volatilization of SiO and oxygen, and can effectively reduce the oxygen content of the crystal rod at the head. Theoretically, a lower furnace pressure indicates a more significant effect of reducing oxygen.

In this embodiment of the present application, crystal pulling is performed by using the constant-diameter initial furnace pressure of 3 Torr, so that a manner of reducing the head oxygen content in the crystal can be effectively implemented while the crystallization efficiency is stable. In an actual embodiment, the head oxygen content is reduced by more than 3 ppm. In addition, a large argon flow rate is used at the constant-diameter head, so that not only accuracy of a resistance hit ratio of the head can be improved, but also heat can be rapidly taken away by using the large argon flow rate, thereby greatly improving a pulling rate in first 50% of constant-diameter growth.

In a specific embodiment, the performing Czochralski crystal growth by lowering a crystal pulling furnace pressure from the sixth furnace pressure according to an actual constant-diameter growth length of doped monocrystalline silicon includes:

controlling a crystal pulling furnace pressure at an initial phase of constant-diameter growth to be within a range of 5 mTorr to 3 Torr; and a crystal pulling furnace pressure at a final phase of constant-diameter growth to be less than or equal to 5 mTorr.

In this embodiment, a crystal pulling process at a furnace pressure ranging from 5 mTorr to 3 Torr higher than that of the final phase of constant-diameter growth is used at the initial phase of constant-diameter growth, thereby reducing volatilization of the dopant and improving accuracy of a head resistance hit ratio; while a lower-furnace-pressure crystal pulling process at a crystal pulling furnace pressure less than 5 mTorr is used at the final phase of constant-diameter growth, which can promote volatilization of the dopant at the middle and late stages of constant-diameter growth, thereby improving the tail resistivity, and increasing the constant-diameter length of the crystal.

In a specific embodiment, the performing Czochralski crystal growth by lowering a crystal pulling furnace pressure from the sixth furnace pressure according to an actual constant-diameter growth length of doped monocrystalline silicon includes:

controlling a crystal rotation rate to be within a range of 5 to 11 RPM and a crucible rotation rate to be within a range of 4 to 9 RPM.

In this embodiment of the present application, at the constant-diameter growth node, the crystal rotation rate is controlled to be within a range of 5 to 11 RPM and remain stable, for example, 5 RPM, 8 RPM, or 11 RPM, and the crucible rotation rate is controlled to be within a range of 4 to 9 RPM and gradually increase, that is, a low crucible rotation rate is used at the head, the action of forcible heat convection weakens, and the thickness of the diffusion boundary layer between the crucible and the melt increases, so that entry of oxygen atoms into the melt can be effectively reduced. In another aspect, the radial temperature gradient of the melt is reduced, the temperature of the wall of the quartz crucible is reduced, the dissolution reaction rate of the quartz crucible is reduced, and the oxygen content in the crystal can also be reduced.

In a specific embodiment, the performing Czochralski crystal growth by lowering a crystal pulling furnace pressure from the sixth furnace pressure according to an actual constant-diameter growth length of doped monocrystalline silicon includes:

controlling a pulling rate to be within a range of 75 mm/hr to 120 mm/hr and a crucible rotation rate to be within a range of 5 RPM to 6 RPM.

In this specific embodiment, at the constant-diameter growth stage, the crucible rotation rate is controlled to increase from 5 RPM to 6 RPM, and the pulling rate ranges from 75 mm/hr to 120 mm/hr, and is increased first and then decreased, so that the crystal pulling efficiency can be effectively improved while reducing the oxygen content in the crystal and ensuring the quality of the crystal.

In a specific embodiment, an argon flow rate at the initial phase of constant-diameter growth is set to be within a range of 50 to 200 L/min; and an argon flow rate at the final phase of the constant-diameter growth is less than 5 L/min.

In this embodiment, crystal pulling at a higher furnace pressure than that of the constant-diameter tail and a large argon flow rate are used at the constant-diameter head, so that not only accuracy of a resistance hit ratio of the head can be improved, but also heat can be rapidly taken away by using the large argon flow rate, thereby greatly improving a pulling rate in first 50% of constant-diameter growth.

In a specific embodiment, the constant-diameter growth initial phase is a constant-diameter growth stage corresponding to the constant-diameter head, the constant-diameter growth final phase is a constant-diameter growth stage corresponding to the constant-diameter tail, a length of the constant-diameter head is less than or equal to 10% of a total length of a constant-diameter part, and a length of the constant-diameter tail is greater than 85% of the total length of the constant-diameter part.

In a specific embodiment, the performing Czochralski crystal growth by lowering a crystal pulling furnace pressure from the sixth furnace pressure according to an actual constant-diameter growth length includes:

controlling, in response to increasing the actual constant-diameter growth length from zero to less than or equal to 5% of a total length of a constant-diameter part, a furnace pressure to be within a range of 0.3 to 3 Torr, an argon flow rate to be within a range of 15 L/min to 50 L/min, and a heating power to decrease by 2.5 Kw.

In the foregoing specific embodiment, at a growth stage in which a length of a pulled crystal rod falls within first 5% of a total rod length of the crystal, for example, when the crystal rod is stretched from 0 mm to 300 mm, the furnace pressure is controlled to decrease from 3 Torr to 0.3 Torr, the argon flow rate is controlled to decrease from 50 L/min to 15 L/min, and the heating power is controlled to decrease by 2.5 Kw. In an embodiment, the foregoing furnace pressure may be 0.3 Torr, 0.5 Torr, 1 Torr, 2 Torr, or the like.

If the decrease amplitude of the furnace pressure is excessively large, excessively large fluctuation of the furnace pressure is likely to cause a non-uniform temperature gradient of the thermal field and an increase of the crystal edge breaking frequency, reducing the production efficiency. In addition, a pulling rate increase is set for matching an early stage of constant-diameter growth, to increase production efficiency, and constant-diameter power is controlled to gradually decrease by 2.5 kw, thereby relieving problems that a pulling rate cannot be increased because the thermal insulation performance of the furnace chamber is increased, heat accumulation is high, and latent heat of crystallization at the crystal-growth solid-liquid interface cannot be excluded in time. If the total constant-diameter temperature reduction is excessively large, the supercooling degree increases, and the crystal growth is prone to an excessively high pulling rate, which easily causes deformation of the crystal rod and edge breaking of the crystal line. The temperature reduction amplitude is affected by a plurality of aspects, such as the thermal insulation performance of the thermal field, a size of the thermal field, and a liquid-mouth distance.

In addition, because the furnace pressure continuously decreases, and the foregoing argon flow rate and dry pump frequency enables the furnace pressure of the furnace chamber to reach the set value as soon as possible; and a lower furnace pressure can reduce convective heat transfer and thermal conductive heat dissipation according to a heat transmission manner and a principle of vacuum thermal insulation performance, the thermal insulation performance of the furnace chamber can be improved.

In a specific embodiment, the performing Czochralski crystal growth by lowering a crystal pulling furnace pressure from the sixth furnace pressure according to an actual constant-diameter growth length includes:

controlling, in response to increasing the actual constant-diameter growth length from 5% of a total length of a constant-diameter part to less than or equal to 10% of the total length of the constant-diameter part, a furnace pressure to be within a range of 5 mTorr to 0.3 Torr and an argon flow rate to be within a range of 5 L/min to 15 L/min.

In the foregoing specific embodiment, at a growth stage in which a length of a pulled crystal rod falls within first 5% to 10% of a total rod length of the crystal, for example, when the length of the crystal rod is stretched from 300 mm to approximately 550 mm, the furnace pressure is controlled to gradually decrease from 0.3 Torr to a minimum furnace pressure of 5 mTorr, and the argon flow rate is controlled to decrease from 15 L/min to 5 L/min, to urge the dopant in the melt to be effectively volatilized, which can reduce differences in axial concentration distribution of a doping element in doped monocrystalline silicon, improve the uniformity of axial resistivity of the monocrystalline silicon. Theoretically, a lower furnace pressure indicates greater volatilization of the dopant, and volatilization of the dopant is greater than segregation, so that the head-to-tail resistivity of the crystal is more concentrated and the axial resistivity distribution of the monocrystalline silicon rod is more uniform.

In a specific embodiment, the performing Czochralski crystal growth by lowering a crystal pulling furnace pressure from the sixth furnace pressure according to an actual constant-diameter growth length includes:
controlling, in response to increasing the actual constant-diameter growth length from 10% of a total length of a constant-diameter part to less than or equal to 55% of the total length of the constant-diameter part, a furnace pressure to be not greater than 5 mTorr and an argon flow rate to be not less than 5 L/min.

In this specific embodiment, at a growth stage in which a length of a pulled crystal rod falls within first 10% to 55% of a total rod length of the crystal, for example, when the length of the crystal rod is stretched from 550 mm to 3000 mm, the furnace pressure is controlled to be less than or equal to 5 mTorr and the argon flow rate is controlled to be greater than or equal to 5 L/min. The furnace pressure and the argon flow rate are moderate, so that the middle part of the crystal rod can be quickly, uniformly, and stably stretched.

In a specific embodiment, the performing Czochralski crystal growth by lowering a crystal pulling furnace pressure from the sixth furnace pressure according to an actual constant-diameter growth length includes:
controlling, in response to increasing the actual constant-diameter growth length from 55% of a total length of a constant-diameter part to less than or equal to 100% of the total length of the constant-diameter part, a furnace pressure to be within a range of 1 mTorr to 5 mTorr, an argon flow rate to be 5 L/min, and a dry pump frequency to be 55 Hz.

In this specific embodiment, at a growth stage of the tail of the crystal rod, for example, when the length of the crystal rod is stretched from 3000 mm to 5500 mm, the furnace pressure is controlled to be within a range of 1 mTorr to 5 mTorr, the argon flow rate is controlled to be 5 L/min, and the dry pump frequency is controlled to be 55 Hz, to force the dopant to be further volatilized, thereby ensuring that the tail of the crystal rod has a high resistivity.

At the growth stage of the tail of the crystal rod, because the remaining material amount in the furnace continuously decreases, the heat dissipation area is enlarged, the location of the crucible continuously increases, and the melt is far away from a heat generating zone of the heater. To prevent the melt from undergoing temperature rise treatment due to supercooling and crystallization, when the length of the crystal rod is stretched from 4200 mm to 5500 mm, it is required that the constant-diameter heating power is controlled to increase by approximately 5 kw.

In this embodiment of the present application, during the performing Czochralski crystal growth by lowering a crystal pulling furnace pressure from the sixth furnace pressure, the pulling rate is negatively correlated to the heater power. For example, at a growth stage in which a length of a pulled crystal rod falls within first 10% to 55% of a total rod length of the crystal, that is, during the stretching the length of the crystal rod from 550 mm to 3000 mm, the pulling rate is controlled to be increased from 100 mm/hr to 120 mm/hr, and the heating power is gradually reduced by 1.8 kw.

In an embodiment, during the performing Czochralski crystal growth by lowering a crystal pulling furnace pressure from the sixth furnace pressure, a pulling rate increment $\Delta V$ and a power increment $\Delta P$ satisfy $\Delta V = -K * \Delta P$, where K ranges from 0.06 to 0.11. By using the foregoing relational expression, the pulling rate may be linearly adjusted based on a change of the heater power, to ensure the stability of the crystal rod.

In an embodiment, the single crystal furnace used in the crystal growth method provided in this embodiment of the present application includes n dry pumps disposed in parallel to form a vacuumization apparatus, and therefore a furnace pressure P of a single crystal furnace, a dry pump quantity n, a dry pump frequency f, and an argon flow rate Q satisfy the following relational expression:

$$P = A/(n * f) - B/Q + C$$

where A ranges from 1 to 120, B ranges from 1 to 100, C ranges from 0 to 0.05, and $Q \geq 1$ L/min.

Performance parameters of the dry pumps are the same, and A, B, C, and Q are constants related to a system configuration, and are measured in advance through an experiment.

In this specific embodiment, provided that an argon flow rate is given, the furnace pressure of the single crystal furnace may be adjusted to the target furnace pressure by controlling the number of dry pumps participating in vacuumization and the frequency of each dry pump.

In an embodiment, before step 701, step 704 is further included:
Step 704: Perform, after the silicon material is melted, secondary addition of the silicon material and the dopant under a condition that the argon flow rate ranges from 100 to 200 L/min and the furnace pressure ranges from 10 to 100 Torr.

In this step, after the silicon material in the quartz crucible is melted, secondary feeding is performed. The addition of the silicon material and the dopant is completed by using a quartz feeding barrel or feeding apparatus. The argon flow rate is set to be within a range of 100 to 200 L/min, and the pressure in the furnace is increased to be within a range of 10 to 100 Torr. The high furnace pressure can prevent effective volatilization of the dopant, and ensure stability of the doping amount and uniformity of the concentration in the furnace. However, when the argon flow rate is excessively small, volatile matters in a feeding process cannot be smoothly discharged out of the furnace with the airflow, and the volatile matters are likely to accumulate in the furnace. When the argon flow rate is excessively large, the dry pump cannot adjust the furnace pressure to be within a range of 10 to 100 Torr, and therefore, the argon flow rate is set to be within a range of 100 to 200 L/min.

In an embodiment, when secondary addition of the silicon material and the dopant is performed, the argon flow rate is set to be within a range of 100 to 150 L/min, and the furnace pressure is set to be within a range of 10 to 100 Torr.

The foregoing dopant may be phosphorus, arsenic, boron, gallium, or the like.

In this embodiment of the present application, in the operations of temperature adjustment, seed dipping, shouldering, and shoulder formation, a low furnace pressure less than or equal to 3 Torr is used, so that under stable seed dipping-shouldering quality, a low furnace pressure state of constant-diameter growth can be quickly reached. Moreover, the crystal pulling furnace pressure is continuously reduced as the constant-diameter growth length increases, so that the dopant can be prevented from being volatilized at an early stage of constant-diameter growth, to ensure stability of the doping amount in the furnace, which not only can improve uniformity of head resistivity and accuracy of head doping, but also can improve a head pulling rate. In addition, at middle and late stages of constant-diameter growth, use of a lower furnace pressure can promote volatilization of the dopant at the middle and late stages of constant-diameter growth, thereby improving the tail resistivity, and increasing the constant-diameter length of the crystal. Therefore, this embodiment of the present application can reduce differences in axial concentration distribution of a doping element in doped monocrystalline silicon, improve the uniformity of axial resistivity of the monocrystalline silicon, and also improve production efficiency.

During actual application, in the crystal growth method provided in the present application, specific steps are as follows:

The quartz crucible filled with the silicon material is hung into the single crystal furnace, and after furnace closing is completed, the furnace body is vacuumized to a preset degree of vacuum, and pressure maintaining is performed, so as to complete confirmation of a leakage rate and air tightness of the device, and perform pressurization and melting after it is confirmed that a leakage rate of normal operation of the device is met, where during the pressure maintaining, an argon flow rate may be set to be within a range of 50 to 200 L/min, and an evacuation speed in the furnace may be increased by introducing argon for a plurality of times;

during the melting, the argon flow rate is set to be within a range of 50 to 120 L/min, the furnace pressure is maintained to be less than 1 Torr, and heating and melting of the silicon material in the quartz crucible are completed by using a main heater and a bottom heater;

after the silicon material in the quartz crucible is melted, secondary addition of the silicon material and the dopant is completed by using a quartz feeding barrel or feeding apparatus under a condition that the argon flow rate ranges from 100 to 200 L/min and the furnace pressure ranges from 10 to 100 Torr;

the melting rate of the material lump in the quartz crucible is observed, and after the silicon material is completely melted, seed crystal temperature testing, splicing, and temperature stabilization are performed under a condition that the argon flow rate ranges from 50 to 200 L/min and the furnace pressure is less than or equal to 3 Torr, so as to complete a temperature adjustment operation;

after temperature adjustment and a seed dipping standard is reached, automatic seed dipping-shouldering is performed under the condition that the argon flow rate ranges from 50 to 200 L/min and the furnace pressure is less than or equal to 3 Torr;

after the seed dipping-shouldering is completed, a constant-diameter growth stage is entered, and at an early stage of the constant-diameter growth, a furnace pressure is controlled to be less than or equal to 3 Torr, and an argon flow rate is set to be within a range of 50 to 200 L/min, so as to take away more heat by using a large argon flow rate, thereby improving a head pulling rate;

as the constant-diameter growth length increases, the furnace pressure is controlled to gradually decrease, and after the constant-diameter growth length reaches 10% of the total length of the constant-diameter part, the furnace pressure is controlled to decrease to be less than 5 mTorr, and the argon flow rate is controlled to decrease to be less than 5 L/min, so as to promote, by using a low furnace pressure, acceleration of volatilization of the dopant in the furnace at middle and late stages of constant-diameter growth, improve the tail resistivity, and increase the constant-diameter length of the crystal;

ending is performed under a condition that the argon flow rate is less than 5 L/min and the furnace pressure is less than 5 mTorr after the length of the crystal rod reaches an ending length or weight; and

after the ending is completed, a crystal rod extraction step is performed under the condition that the argon flow rate ranges from 100 to 200 L/min and the furnace pressure ranges from 10 to 100 Torr.

That is, in this embodiment of the present application, in processes of vacuumization and leakage detection, feeding, melting, seed dipping and shouldering, constant-diameter growth, and ending of the single crystal furnace, the head-to-tail resistivity of the crystal is improved by using different changes of the furnace pressure, so that the attenuation of the resistivity of the crystal rod per 100 cm is reduced by more than 65% compared with the attenuation of that in the crystal pulling at the conventional furnace pressure, thereby improving the production efficiency.

An embodiment of the present application further provides crystalline silicon, prepared by using the crystal growth method described above, where an oxygen content of the crystalline silicon is less than or equal to 11 ppma.

Temperature adjustment, seed dipping, shouldering, and shoulder formation are performed at a low furnace pressure less than or equal to 3 Torr during preparation of the foregoing doped monocrystalline silicon. Therefore, under stable seed dipping-shouldering quality, a low furnace pressure state of constant-diameter growth can be quickly reached. As the Czochralski crystal growth proceeds, the crystal pulling furnace pressure is continuously reduced, so that the dopant can be prevented from being volatilized at an early stage of constant-diameter growth, to ensure stability of the doping amount in the furnace, which not only can improve uniformity of head resistivity and accuracy of head doping, but also can improve a head pulling rate. In addition, at middle and late stages of constant-diameter growth, use of a lower furnace pressure can promote volatilization of the dopant at the middle and late stages of constant-diameter growth, thereby improving the tail resistivity, and increasing the constant-diameter length of the crystal, thereby reducing differences in axial concentration distribution of a doping element in doped monocrystalline silicon, so that the uniformity of axial resistivity of the doped monocrystalline silicon is higher.

**Embodiment six**

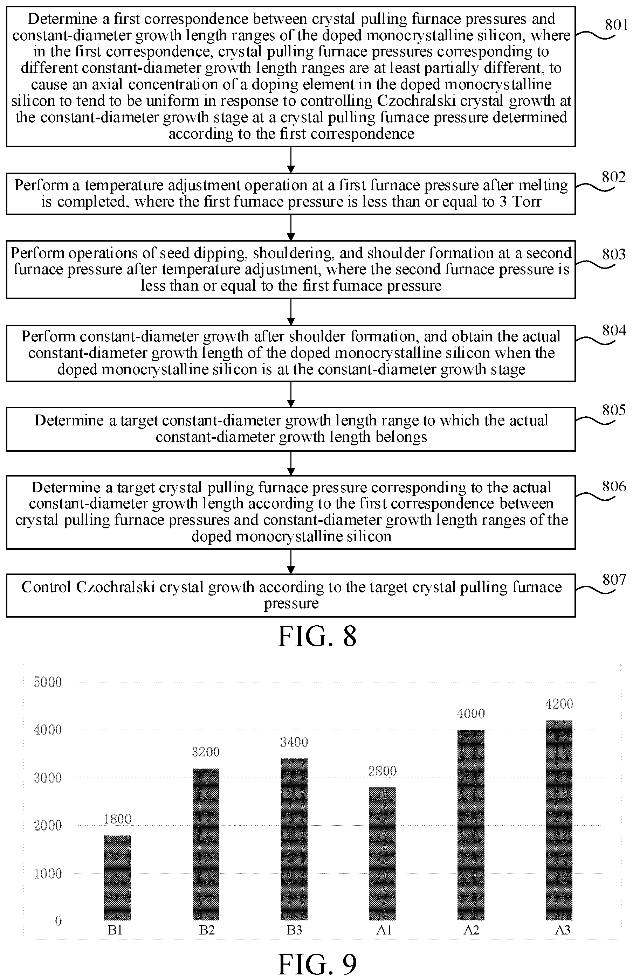

Referring to FIG. 8, FIG. 8 is a flowchart of steps of a crystal growth method according to embodiment six of the present application. The method may include step 801 to step 804:

Step 801: Determine a first correspondence between crystal pulling furnace pressures and constant-diameter growth length ranges of the doped monocrystalline silicon, where in the first correspondence, crystal pulling furnace pressures corresponding to different constant-diameter growth length ranges are at least partially different, to cause an axial concentration of a doping element in the doped monocrystalline silicon to tend to be uniform in response to controlling Czochralski crystal growth at the constant-diameter growth stage at a crystal pulling furnace pressure determined according to the first correspondence.

In this step, starting from a law that an axial concentration distribution of monocrystalline silicon is non-uniform because a doping element is subject to crystal pulling furnace pressures in different constant-diameter growth lengths, a crystal pulling furnace pressure that can make a saturated vapor pressure of the doping element in the doped monocrystalline silicon at a constant-diameter growth stage constantly change in gradient with constant-diameter growth of the monocrystalline silicon to control the axial concentration of the doping element to tend to be uniform is calculated in advance, that is, the foregoing first correspondence is determined.

Specifically, the total length of constant-diameter growth may be uniformly or non-uniformly divided into a plurality of constant-diameter growth length ranges, and then a different crystal pulling furnace pressure is set for each constant-diameter growth length range.

In an embodiment, in the foregoing first correspondence, crystal pulling furnace pressures and constant-diameter growth length ranges of the doped monocrystalline silicon are negatively correlated. That is, in the foregoing first correspondence, the crystal pulling furnace pressure decreases in gradient as the constant-diameter growth length range increases, so that when the crystal pulling furnace pressure is adjusted according to the foregoing first correspondence, not only the axial concentration of the doping element can be controlled to tend to be uniform, but also the crystal pulling quality can be further improved.

In an embodiment, in the foregoing first correspondence, crystal pulling furnace pressures and constant-diameter growth length ranges of the doped monocrystalline silicon may have a linear negative correlation, a curvilinear negative correlation, or a gradient negative correlation. That is, as the constant-diameter growth length range increases, the crystal pulling furnace pressure continuously decreases.

Step 802: Perform a temperature adjustment operation at a fifth furnace pressure after a silicon material is melted, where the fifth furnace pressure is less than or equal to 3 Torr.

For details of this step, refer to the foregoing step 701, and details are not described herein again.

Step 803: Perform operations of seed dipping, shouldering, and shoulder formation at a sixth furnace pressure after temperature adjustment, where the sixth furnace pressure is less than or equal to the fifth furnace pressure.

For details of this step, refer to the foregoing step 702, and details are not described herein again.

Step 804: Perform constant-diameter growth after shoulder formation, and obtain the actual constant-diameter growth length of the doped monocrystalline silicon when the doped monocrystalline silicon is at the constant-diameter growth stage.

In this step, since the doped monocrystalline silicon enters the constant-diameter growth stage, the constant-diameter growth length of the doped monocrystalline silicon is continuously monitored and obtained, and is used as the foregoing actual constant-diameter growth length.

Step 805: Determine a target constant-diameter growth length range to which the actual constant-diameter growth length belongs.

In this step, according to the obtained actual constant-diameter growth length and the upper limit of the constant-diameter growth length and the lower limit of the constant-diameter growth length that correspond to each constant-diameter growth length range in the first correspondence, a constant-diameter growth length range that includes the actual constant-diameter growth length is determined, and is used as the target constant-diameter growth length range.

Step 806: Determine a target crystal pulling furnace pressure corresponding to the actual constant-diameter growth length according to the first correspondence between crystal pulling furnace pressures and constant-diameter growth length ranges of the doped monocrystalline silicon.

In this step, the foregoing first correspondence specifies crystal pulling furnace pressures corresponding to different constant-diameter growth length ranges. Therefore, after a constant-diameter growth length range for an actual constant-diameter growth length is determined, a crystal pulling furnace pressure corresponding to the actual constant-diameter growth length, that is, the foregoing target crystal pulling furnace pressure may be determined.

Step 807: Control Czochralski crystal growth according to the target crystal pulling furnace pressure.

In this step, in response to controlling Czochralski crystal growth at the constant-diameter growth stage at the crystal pulling furnace pressure determined according to the first correspondence, the saturated vapor pressure of the doping element in the doped monocrystalline silicon constantly changes, to make the axial concentration of the doping element tend to be uniform. Therefore, in response to controlling Czochralski crystal growth according to the target crystal pulling process parameter, a difference in concentration distribution of the doping element in the monocrystalline silicon is small, and the axial resistivity of the silicon crystal becomes uniform.

In an embodiment, step 807 specifically includes step 871:

Step 871: Adjust crystal pulling process parameters according to the target crystal pulling furnace pressure, where the crystal pulling process parameters include an argon flow rate and a dry pump frequency.

In this embodiment, because a high argon flow rate can take away more heat, a crystal pulling rate of the monocrystalline silicon is improved. However, due to a limitation on performance of a dry pump, when the dry pump reaches a frequency upper limit, the crystal pulling furnace pressure can be continuously reduced only by reducing the argon flow rate. Therefore, by adjusting the argon flow rate and the dry pump frequency, a required crystal pulling furnace pressure can be achieved within a performance range of the dry pump.

In a specific embodiment, before step 807, step 8710 is further included, and step 871 includes step 8711 to step 8712.

Step 8710: Determine a second correspondence among crystal pulling furnace pressures of the doped monocrystalline silicon, argon flow rates, and dry pump frequencies, where in response to controlling Czochralski crystal growth according to an argon flow rate and a dry pump frequency that are determined according to the second correspondence, a crystal pulling furnace pressure of the doped monocrystalline silicon is adjusted to a corresponding pressure value, and a crystal pulling rate of the doped monocrystalline silicon tends to be a maximum value.

In this step, a large argon flow rate can take away more heat and can improve a crystal pulling rate. However, when the furnace pressure is not changed, a larger argon flow rate indicates a higher required dry pump frequency, while the dry pump is limited by performance and has a frequency upper limit. That is, when the furnace pressure is not changed, a crystal pulling rate of the monocrystalline silicon is determined by both the argon flow rate and the dry pump frequency. Therefore, starting from a law that a large argon flow rate can take more heat and can improve the crystal pulling rate, a maximum argon flow rate for achieving each crystal pulling furnace pressure within a working frequency range of the dry pump, that is, the foregoing second correspondence is determined with reference to the working performance of the dry pump.

Step 8711: Determine a target argon flow rate and a target dry pump frequency that correspond to the target crystal pulling furnace pressure according to the second correspondence among crystal pulling furnace pressures of the doped monocrystalline silicon, argon flow rates, and dry pump frequencies.

In this step, an argon flow rate and a dry pump frequency at each crystal pulling furnace pressure are determined in the second correspondence. Therefore, when the target crystal pulling furnace pressure is obtained, the corresponding argon flow rate and dry pump frequency, that is, the target argon flow rate and the target dry pump frequency may be determined by using the second correspondence.

Step 8712: Control Czochralski crystal growth according to the target argon flow rate and the target dry pump frequency.

In this step, a maximum argon flow rate for achieving each crystal pulling furnace pressure in a working frequency range of the dry pump is determined in the second correspondence. Therefore, Czochralski crystal growth is controlled at the target argon flow rate and the target dry pump frequency, so that not only a target crystal pulling furnace pressure can be achieved, but also crystal pulling can be performed at a maximum value of the crystal pulling rate, thereby improving an overall crystal pulling rate.

In a specific embodiment, in the foregoing second correspondence, the crystal pulling furnace pressure is positively correlated with the argon flow rate. That is, it is set that as the crystal pulling furnace pressure decreases, the argon flow rate also continuously decreases, thereby effectively improving the head crystal pulling rate of the crystal.

In the foregoing embodiment, when the doped monocrystalline silicon is at the constant-diameter growth stage, a corresponding target crystal pulling furnace pressure is first determined according to an actual constant-diameter growth length, and then a corresponding argon flow rate and dry pump frequency are determined according to the target crystal pulling furnace pressure, to control Czochralski crystal growth. In this way, not only a lowered target crystal pulling furnace pressure can be achieved, to relieve a difference in axial resistivity of the monocrystalline silicon, but also crystal pulling can be performed at a maximum value of a crystal pulling rate, thereby improving an overall crystal pulling rate.

In an embodiment, the crystal pulling process parameters further include a crucible rotation rate, a crystal pulling rate, and a heater power. Before step 871, step 8720 is further included, and step 871 includes step 8721 to step 8722.

Step 8720: Determine a third correspondence among crystal pulling furnace pressures of the doped monocrystalline silicon, argon flow rates, dry pump frequencies, crucible rotation rates, crystal pulling rates, and heater powers, where in response to controlling Czochralski crystal growth according to an argon flow rate, a dry pump frequency, a crucible rotation rate, and a heater power that are determined according to the third correspondence, a crystal pulling furnace pressure of the doped monocrystalline silicon is adjusted to a corresponding pressure value, and a crystal pulling rate of the doped monocrystalline silicon tends to be a maximum value.

In this step, a large argon flow rate can take away more heat and can improve a crystal pulling rate; and reduction of the heater power can reduce generation of heat, thereby further improving the crystal pulling rate; and an increase in the crucible rotation rate can accelerate temperature reduction, thereby increasing the crystal pulling rate. However, when the furnace pressure is not changed, a larger argon flow rate indicates a higher required dry pump frequency, while the dry pump is limited by performance and has a frequency upper limit. In addition, an excessively low heater power and an excessively high crucible rotation rate affect a state of melted silicon and crystal pulling quality. That is, when the furnace pressure is not changed, a crystal pulling rate of the monocrystalline silicon is determined by all of the argon flow rate, the dry pump frequency, the heater power, and the crucible rotation rate. Therefore, starting from a law that a large argon flow rate can take more heat and a low heater power and a high crucible rotation rate can improve the crystal pulling rate, a maximum argon flow rate, a minimum heater power, and a maximum crucible rotation rate for achieving each crystal pulling furnace pressure within a working frequency range of the dry pump, that is, the foregoing third correspondence is determined with reference to the working performance of the dry pump.

Step 8721: Determine a target argon flow rate, a target crucible rotation rate, a target crystal pulling rate, and a target heating power that correspond to the target crystal pulling furnace pressure according to the third correspondence among crystal pulling furnace pressures of the doped monocrystalline silicon, argon flow rates, dry pump frequencies, crucible rotation rates, crystal pulling rates, and heater powers.

In this step, an argon flow rate, a dry pump frequency, a heater power, and a crucible rotation rate at each crystal pulling furnace pressure are determined in the third correspondence. Therefore, when the target crystal pulling furnace pressure is obtained, the corresponding argon flow rate, dry pump frequency, heater power, and crucible rotation rate, that is, the target argon flow rate, the target dry pump frequency, the target heater power, and the target crucible rotation rate may be determined by using the third correspondence.

Step 8722: Control Czochralski crystal growth according to the target argon flow rate, the target dry pump frequency, the target heater power, and the target crystal pulling rate.

In this step, a maximum argon flow rate, a proper heater power, and a proper crucible rotation rate for achieving each crystal pulling furnace pressure in a working frequency range of the dry pump is determined in the third correspondence. Therefore, Czochralski crystal growth is controlled at the target argon flow rate, the target dry pump frequency, the target heater power, and the target crucible rotation rate, so that not only a target crystal pulling furnace pressure can be achieved, but also crystal pulling can be performed at a maximum value of the crystal pulling rate, thereby improving an overall crystal pulling rate.

In the foregoing embodiment, when the doped monocrystalline silicon is at the constant-diameter growth stage, a corresponding target crystal pulling furnace pressure is first determined according to an actual constant-diameter growth length, and then a corresponding argon flow rate, crucible rotation rate, dry pump frequency, heater power, and crystal pulling rate are determined according to the target crystal pulling furnace pressure, to control Czochralski crystal growth. In this way, not only a smoothly lowered target crystal pulling furnace pressure can be achieved, to relieve a difference in axial resistivity of the monocrystalline silicon, but also crystal pulling can be performed at a maximum value of a crystal pulling rate, thereby improving an overall crystal pulling rate.

The present application is described in detail below by using examples.

Example 2

Descriptions are provided by using an example in which a thermal field is 32 inches in size, a maximum rod length is 5500 mm, and a constant-diameter whole-process crystal rotation rate is 8 RPM:

(1) A quartz crucible filled with a silicon material is hung into a single crystal furnace, the single crystal furnace is vacuumized after furnace closing is completed, pressurization and melting are performed after vacuumization of the single crystal furnace is completed, where the crucible rotation rate is set to 1 RPM, the heater power is set to 250 Kw, the argon flow rate is set to 50 L/min, the furnace pressure is set to 1 Torr, and the dry pump frequency is set to 45 Hz.

(2) After the silicon material in the quartz crucible is melted, secondary addition of the silicon material and the dopant is completed by using a quartz feeding barrel or feeding apparatus, where the crucible rotation rate is set to 1 RPM, the heater power is set to 250 Kw, the argon flow rate is set to 100 L/min, the furnace pressure is set to 15 Torr, and the dry pump frequency is set to 50 Hz.

(3) After the silicon material is completely melted, seed crystal temperature testing, splicing, and temperature stabilization are performed, so as to complete a temperature adjustment operation, where the crystal rotation rate is set to 8 RPM, the crucible rotation rate is set to 5 RPM, the argon flow rate is set to 50 L/min, the furnace pressure is set to 3 Torr, and the dry pump frequency is set to 30 Hz.

(4) After temperature adjustment is completed and a seed dipping standard is reached, automatic seed dipping-shouldering is performed, where the crystal rotation rate is set to 8 RPM, the crucible rotation rate is set to 5 RPM, the argon flow rate is set to 50 L/min, the furnace pressure is set to 3 Torr, and the dry pump frequency is set to 30 Hz.

(5) After temperature adjustment is completed and a seed dipping standard is reached, automatic seed dipping-shouldering is performed, where the crystal rotation rate is set to 8 RPM, the crucible rotation rate is set to 5 RPM, the argon flow rate is set to 50 L/min, the furnace pressure is set to 3 Torr, and the dry pump frequency is set to 30 Hz.

(6) After seed dipping-shouldering is completed, a constant-diameter growth stage is entered, and crystal pulling process parameters are adjusted according to the following Table 3, to obtain doped monocrystalline silicon.

In Embodiment 2, the crystal pulling process at a low furnace pressure as low as 5 mTorr is used, and compared with a conventional furnace pressure (more than 10 Torr), the entire oxygen content of the crystal is reduced by approximately 3 ppm, where the head oxygen content is reduced by more than 3 ppm, the middle oxygen content of the crystal is reduced by more than 2 ppm, and the tail oxygen content is reduced by more than 2.5 ppm.

Table 3

| Crystal pulling step | | Crucible rotation rate (RPM) | Power (Kw) | Pulling rate (mm/hr) | argon flow rate (L/min) | Furnace pressure (Torr) | Dry pump frequency (Hz) |
|---|---|---|---|---|---|---|---|
| Pressurization and melting | | 1 | 250 | / | 50 | 1 | 45 |
| Feeding | | 1 | 250 | / | 100 | 15 | 50 |
| Temperature adjustment | | 5 | / | / | 50 | 3 | 30 |
| Seeding-shoulder formation | | 5 | / | / | 50 | 3 | 30 |
| Constant-diameter | 0% * rod length | 5 | 45 | 75 | 50 | 3 | 30 |
| | 1% * rod length | 5 | 44.5 | 80 | 40 | 2 | 35 |
| | 2% * rod length | 5.3 | 43.9 | 87 | 30 | 1 | 40 |
| | 3.5% * rod length | 5.7 | 43.2 | 92 | 20 | 0.5 | 47 |
| | 5% * rod length | 6 | 42.5 | 97 | 15 | 0.3 | 50 |
| | 10% * rod length | 6 | 41.8 | 102 | 5 | 0.005 | 55 |
| | 22% * rod length | 6 | 41.1 | 110 | 5 | 0.005 | 55 |
| | 35% * rod length | 6 | 40.4 | 118 | 5 | 0.005 | 55 |
| | 55% * rod length | 6 | 40.0 | 120 | 5 | 0.005 | 55 |
| | 85% * rod length | 6 | 41.0 | 118 | 5 | 0.005 | 55 |
| | 100% * rod length | 6 | 46.0 | 110 | 5 | 0.005 | 55 |

(continued)

| Crystal pulling step | Crucible rotation rate (RPM) | Power (Kw) | Pulling rate (mm/hr) | argon flow rate (L/min) | Furnace pressure (Torr) | Dry pump frequency (Hz) |
|---|---|---|---|---|---|---|
| Crystal rod extraction | 2 | / | / | 100 | 15 | 50 |

Example 3

Descriptions are provided by using an example in which a thermal field is 32 inches in size, a maximum rod length is 5500 mm, and a constant-diameter whole-process crystal rotation rate is 8 RPM:

(1) A quartz crucible filled with a silicon material is hung into a single crystal furnace, the single crystal furnace is vacuumized after furnace closing is completed, pressurization and melting are performed after vacuumization of the single crystal furnace is completed, where the crucible rotation rate is set to 1 RPM, the heater power is set to 250 Kw, the argon flow rate is set to 50 L/min, the furnace pressure is set to 1 Torr, and the dry pump frequency is set to 45 Hz.
(2) After the silicon material in the quartz crucible is melted, secondary addition of the silicon material and the dopant is completed by using a quartz feeding barrel or feeding apparatus, where the crucible rotation rate is set to 1 RPM, the heater power is set to 250 Kw, the argon flow rate is set to 100 L/min, the furnace pressure is set to 15 Torr, and the dry pump frequency is set to 50 Hz.
(3) After the silicon material is completely melted, seed crystal temperature testing, splicing, and temperature stabilization are performed, so as to complete a temperature adjustment operation, where the crystal rotation rate is set to 8 RPM, the crucible rotation rate is set to 5 RPM, the argon flow rate is set to 50 L/min, the furnace pressure is set to 3 Torr, and the dry pump frequency is set to 30 Hz.
(4) After temperature adjustment is completed and a seed dipping standard is reached, automatic seed dipping-shouldering is performed, where the crystal rotation rate is set to 8 RPM, the crucible rotation rate is set to 5 RPM, the argon flow rate is set to 50 L/min, the furnace pressure is set to 3 Torr, and the dry pump frequency is set to 30 Hz.
(5) After temperature adjustment is completed and a seed dipping standard is reached, automatic seed dipping-shouldering is performed, where the crystal rotation rate is set to 8 RPM, the crucible rotation rate is set to 5 RPM, the argon flow rate is set to 50 L/min, the furnace pressure is set to 3 Torr, and the dry pump frequency is set to 30 Hz.
(6) After seed dipping-shouldering is completed, a constant-diameter growth stage is entered, and crystal pulling process parameters are adjusted according to the following Table 4, to obtain doped monocrystalline silicon.

Table 4

| Crystal pulling step | | Crucible rotation rate (RPM) | Power (Kw) | Pulling rate (mm/hr) | argon flow rate (L/min) | Furnace pressure (Torr) | Dry pump frequency (Hz) |
|---|---|---|---|---|---|---|---|
| Pressurization and melting | | 1 | 250 | / | 50 | 1 | 45 |
| Feeding | | 1 | 250 | / | 100 | 15 | 50 |
| Temperature adjustment | | 5 | / | / | 50 | 3 | 30 |
| Seeding-shoulder formation | | 5 | / | / | 50 | 3 | 30 |
| Constant-diameter | 0% * rod length | 5 | 45 | 75 | 50 | 3 | 30 |
| | 1% * rod length | 5 | 44.5 | 80 | 40 | 2 | 35 |
| | 2% * rod length | 5.3 | 43.9 | 87 | 30 | 1 | 40 |
| | 3.5% * rod length | 5.7 | 43.2 | 92 | 20 | 0.5 | 47 |
| | 5% * rod length | 6 | 42.5 | 97 | 15 | 0.4 | 50 |
| | 10% * rod length | 6 | 41.8 | 102 | 5 | 0.3 | 52 |
| | 22% * rod length | 6 | 41.1 | 110 | 5 | 0.2 | 54 |
| | 35% * rod length | 6 | 40.4 | 118 | 5 | 0.1 | 56 |

(continued)

| Crystal pulling step | | Crucible rotation rate (RPM) | Power (Kw) | Pulling rate (mm/hr) | argon flow rate (L/min) | Furnace pressure (Torr) | Dry pump frequency (Hz) |
|---|---|---|---|---|---|---|---|
| | 55% * rod length | 6 | 40.0 | 120 | 5 | 0.005 | 57 |
| | 85% * rod length | 6 | 41.0 | 118 | 5 | 0.003 | 58 |
| | 100% * rod length | 6 | 46.0 | 110 | 5 | 0.001 | 59 |
| Crystal rod extraction | | 2 | / | / | 100 | 15 | 50 |

In Embodiment 3, the crystal pulling process at a low furnace pressure as low as 1 mTorr is used, and compared with a conventional furnace pressure (more than 10 Torr), the entire oxygen content of the crystal is reduced by approximately 3.5 ppm, where the head oxygen content is reduced by more than 3.5 ppm, the middle oxygen content of the crystal is reduced by more than 2.5 ppm, and the tail oxygen content is reduced by more than 3 ppm.

According to an attenuation condition of axial resistivity, and with reference to requirements on electrical performance quality parameter indicators of a monocrystalline silicon rod, rod lengths of a monocrystalline silicon rod A1, a monocrystalline silicon rod A2, and a monocrystalline silicon rod A3 prepared by using Embodiment 2 of the present application in a 26-inch/32-inch/33-inch thermal field are evaluated respectively, and rod lengths of a monocrystalline silicon rod B1, a monocrystalline silicon rod B2, and a monocrystalline silicon rod B3 prepared by using the existing Czochralski method in a 26-inch/32-inch/33-inch thermal field are evaluated respectively, whose results are separately shown in FIG. 9.

It can be learned from FIG. 9 that, according to the same resistivity specification requirement, compared with the existing Czochralski method, by using the low-furnace-pressure crystal pulling process provided in this embodiment of the present application, in combination with a lifetime attenuation situation of a monocrystalline silicon rod, a rod length in 26 inches is actually improved by 55%, a rod length in 32 inches is actually improved by 25%, and a rod length in 33 inches is actually improved by 23.5%.

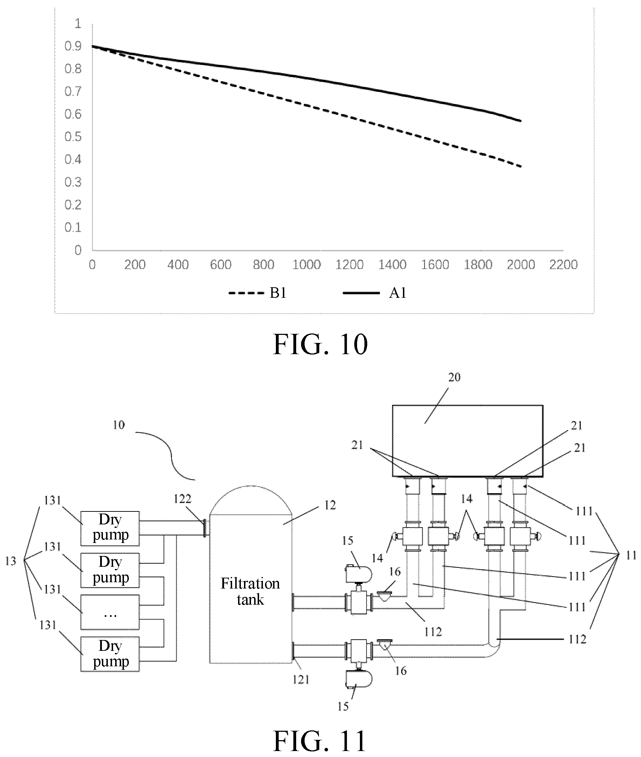

Comparison between actual resistance distributions of the monocrystalline silicon rod A1 and the monocrystalline silicon rod B 1 is shown in FIG. 10.

It can be learned from FIG. 10 that, under a condition of equal rod lengths, compared with the existing Czochralski method, the tail resistivity of the crystal rod actually produced by using the low-furnace-pressure crystal pulling process provided in this embodiment of the present application is increased by more than 65%.

In the existing Czochralski (CZ) crystal pulling process, an argon atmosphere is usually used for decompressing crystal pulling, that is, a flowing argon atmosphere at a reduced pressure ranging from 10 to 20 Torr is formed by introducing an inert gas argon, and in combination with the suction of a vacuum pump. In a process of pulling a doped single crystal such as a gallium-doped monocrystalline silicon by using the Czochralski method, the resistivity of the crystal rod gradually decreases as the length of the crystal rod increases. Consequently, the overall resistivity of the grown crystal rod greatly differs as the length increases, and the length of the crystal rod within the effective range of resistivity is limited.

However, the diameter of an exhaust pipeline of an existing single crystal furnace is usually designed to be 100/120 mm, 200/300 L/s is selected for a vacuum pump, and an argon flow rate is set to be within a range of 60 to 80 L/min. The lowest furnace pressure that is controllably reached is greater than 6 Torr, that is, a requirement for performing crystal pulling at a low furnace pressure less than 6 Torr is not supported, and volatilization of a doping element is limited, that is, a resistivity attenuation rate cannot be effectively reduced.

In view of the foregoing problem, a single crystal furnace vacuum system 10 provided in an embodiment of the present application, as shown in FIG. 11 to FIG. 15, includes an exhaust pipe group, a filtering apparatus 12, and a vacuumization apparatus 13. One end of the exhaust pipe group 11 is in communication with a furnace bottom of a single crystal furnace 20; the other end of the exhaust pipe group 11 is in communication with an air inlet 121 of the filtering apparatus 12; the vacuumization apparatus 13 is in communication with an air outlet 122 of the filtering apparatus 12 by using a vacuum pipeline; and the vacuumization apparatus 13 includes a plurality of vacuum pumps, and the plurality of vacuum pumps are connected in series or in parallel by using the vacuum pipeline.

In the single crystal furnace vacuum system 10 provided in the present application, the furnace bottom of the single crystal furnace 20, the exhaust pipe group, the filtering apparatus 12, and the vacuumization apparatus 13 are connected in sequence through a pipeline, and the vacuumization apparatus 13 includes the plurality of vacuum pumps that are disposed in series or in parallel through the vacuum pipeline. The plurality of vacuum pumps are connected in series or in parallel by using the vacuum pipeline to form the vacuumization apparatus 13, so that vacuumization performance of the vacuumization apparatus 13 can be improved without changing performance of the vacuum pump, to achieve a low furnace pressure effect, thereby increasing volatilization of a doping element at a late stage of constant-diameter growth, and effectively reducing a resistivity attenuation rate of the crystal rod.

In the single crystal furnace vacuum system 10 provided in this embodiment of the present application, the furnace bottom of the single crystal furnace 20 is provided with an exhaust vent 21, and the exhaust vent 21 is connected to the other end of the exhaust pipe group 11. That is, a front end of the exhaust pipe group 11 is in communication with the single crystal furnace 20 through the exhaust vent 21.

In an embodiment, at least two exhaust vents 21 are provided, and a ratio of a total area of the exhaust vents 21 to a total area of the furnace bottom is less than 50%, to provide sufficient remaining furnace bottom space to mount other components.

In an embodiment, at least two exhaust vents 21 are uniformly disposed at the furnace bottom of the single crystal furnace 20, so that the single crystal furnace 20 can be more uniformly vacuumized when the vacuum pump system is operated, thereby achieving a more uniform pressure in the furnace.

In an embodiment, an even number of, for example, 2, 4, 6, or 8 exhaust vents are disposed, to facilitate uniform distribution, to better keep the furnace pressure balanced. In an embodiment, the exhaust vent is circular or square, which can effectively reduce resistance during other flow.

In the single crystal furnace vacuum system 10 provided in this embodiment of the present application, the exhaust pipe group 11 includes a plurality of exhaust pipelines 111 disposed in parallel, and a front end of each exhaust pipeline 111 is connected to one of the exhaust vents 21. That is, the furnace bottom of the single crystal furnace 20 is uniformly provided with the plurality of exhaust vents, and each exhaust vent is in communication with one exhaust pipeline 111, so that vacuumization can be performed at each exhaust vent more efficiently.

In an embodiment, a first throttle valve 14 is disposed on the exhaust pipeline 111 between the exhaust vent and the filtering apparatus 12. In this embodiment, the first throttle valve 14 is disposed on the exhaust pipeline 111 between each exhaust vent and the filtering apparatus 12, so that the first throttle valve 14 can be used to control a flow rate of a gas flowing through the corresponding exhaust pipeline 111, thereby more accurately extracting the gas in the furnace and maintaining a uniform furnace pressure.

In an embodiment, the exhaust pipe group 11 further includes a convergence pipeline 112, tail ends of at least two of the exhaust pipelines 111 are connected to one end of the convergence pipeline 112, and the other end of the convergence pipeline 112 is connected to the air inlet 121 of the filtering apparatus 12 by using a vacuum ball valve 15. That is, the tail ends of the at least two of the foregoing exhaust pipelines 111 merge into the foregoing convergence pipeline.

In an embodiment, when the foregoing exhaust pipe group 11 includes 2N exhaust pipelines 111 disposed in parallel, the exhaust pipelines 111 are combined in pairs and connect to the filtering apparatus 12 through the vacuum ball valve 15. N may be any positive integer.

For example, N may be 2, so that the exhaust pipe group 11 includes four exhaust pipelines disposed in parallel, and there are four exhaust vents 21.

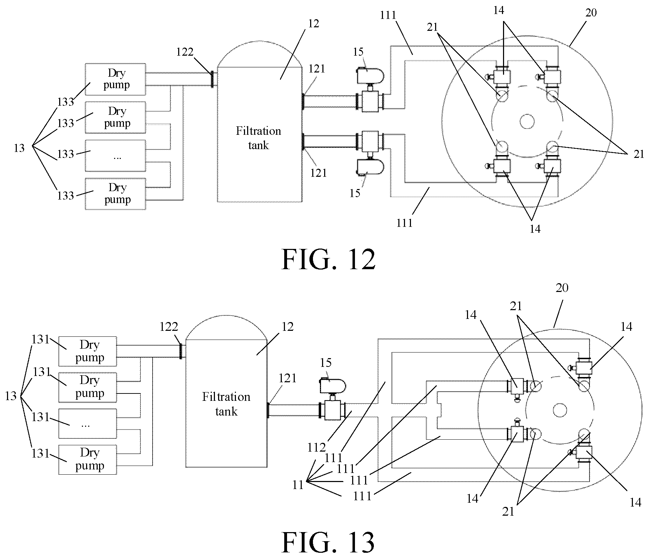

In a specific embodiment, as shown in FIG. 13, four exhaust vents are uniformly disposed along the furnace bottom. Exhaust pipelines 111 are combined in pairs and then connect to a convergence pipeline 112, and then connect to a filtering apparatus 12 through a vacuum ball valve 15.

In another specific embodiment, as shown in FIG. 1 or FIG. 4, four exhaust vents are uniformly disposed along the furnace bottom. Exhaust pipelines 111 are combined in pairs, connect to a convergence pipeline 112, then are connected in parallel, and then connect to a filtering apparatus 12 through a vacuum ball valve 15.

In this embodiment of the present application, based on the vacuumization performance of the existing vacuum pump, through vacuumization performance of a plurality of vacuum pumps superposed in series or in parallel, the single crystal furnace 20 can be controlled to achieve a state of a low furnace pressure less than 1 Pa when a shielding gas such as argon is introduced. Specifically, the single crystal furnace vacuum system 10 provided in this embodiment of the present application can control, in a case that a given argon flow rate ranges from 1 to 10 L/min in the single crystal furnace 20, a gas pressure in the furnace to be within a range of 0.5 to 10 Pa.

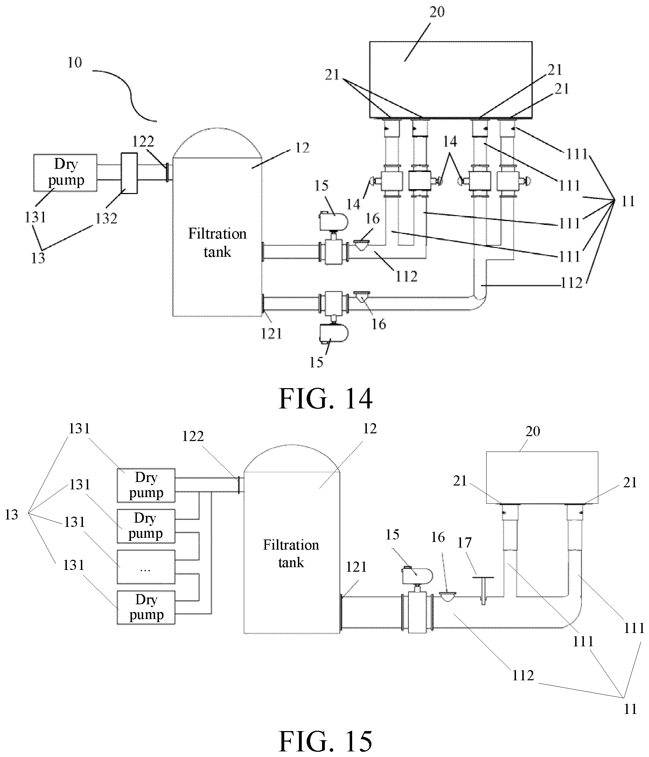

In an embodiment, as shown in FIG. 15, a cross-sectional flow area of the convergence pipeline 112 is greater than a cross-sectional flow area of each exhaust pipeline 111 connected to the convergence pipeline 112. By setting the cross-sectional flow area of the convergence pipeline 112 to be greater than the cross-sectional flow area of each exhaust pipeline 111, flow resistance of the exhaust pipeline 111 can be effectively reduced, so as to further reduce the furnace pressure.

In this embodiment, the cross-sectional flow area of each of the air inlet 121 and the air outlet 122 in the filtering apparatus is equal to that of the convergence pipeline 112. That is, the hole diameters of the air inlet 121 and the air outlet 122 are equal to the pipe diameter of the convergence pipeline 112.

In a specific embodiment, the cross-sectional flow area of the convergence pipeline 112 is not less than a sum of the cross-sectional flow areas of the exhaust pipelines 111 connected to the convergence pipeline 112, so that the exhaust area is not reduced after the exhaust pipelines are merged, thereby reducing flow resistance of the exhaust pipelines, facilitating control of the furnace pressure, and implementing a requirement for performing crystal pulling at a low furnace pressure.

For example, when N is 1, the exhaust pipe group 11 includes 1 convergence pipeline 112 and 2 exhaust pipelines 111 that are disposed in parallel and that have equal pipe diameters, there are 2 exhaust vents 21, and the hole diameter of the exhaust vent 21 is equal to the pipe diameter of the exhaust pipeline 111. That is, the single crystal furnace 20 is provided with two exhaust vents, and after the 2 exhaust pipelines 111 are combined, connect to the convergence pipeline 112, and then connect to the filtering apparatus 12 through the vacuum ball valve 15. Therefore, $S_{Combination} = 2 * S_{Single}$.

The pipe diameter $D_{Combination}$ of the convergence pipeline 112 is calculated in the following formula:

$$D_{Combination} = 2 * \sqrt{2S_{single}/\pi}$$

where $D_{Combination}$ represents the diameter of the convergence pipeline, and $S_{Single}$ represents the cross-sectional flow area of each exhaust pipeline.

For example, if the hole diameter of the exhaust vent is 120 mm, $2 * S_{Single}$ is 22608 mm$^2$, it may be determined that $D_{Combination}$ is 170 mm, and exhaust pipe diameters of the vacuum ball valve 15, the filtering apparatus 12, the vacuumization apparatus 13, and the like are also set to 170 mm.

By using the foregoing single crystal furnace vacuum system 10, a limit furnace pressure can be reduced to 1.5 Torr under a condition that a dry pump in the vacuumization apparatus 13 has a pumping speed of 300 L/s and a frequency of 40 Hz, an argon flow rate is 50 L/min, and a size of a thermal field is 26 inches, so that a furnace pressure reduction effect is good. By using the foregoing single crystal furnace vacuum system 10, in a crystal pulling process at changing furnace pressures, a resistivity range of gallium-doped monocrystalline silicon produced through crystal pulling may be controlled in a range of 0.4 to 1.1 $\Omega \cdot$cm, a weight of a single crystal rod may reach 260 kg, and a pull-out ratio may reach 82%.

In a specific embodiment, a second throttle valve 17 is disposed on the convergence pipeline, so as to facilitate adjustment of the furnace pressure according to a requirement for performing crystal pulling at a low furnace pressure, to satisfy an actual operating condition.

In an embodiment, in the single crystal furnace vacuum system 10 provided in the present application, an anti-explosion port 16 is further disposed on the convergence pipeline 112 on the front side of the vacuum ball valve 15, so that safe operation of the system can be ensured.

In an embodiment, as shown in FIG. 1 to FIG. 3, the plurality of vacuum pumps include a plurality of dry pumps 131, and the plurality of dry pumps 131 are connected in parallel by using the vacuum pipeline. That is, the plurality of dry pumps 131 are connected in parallel by using the vacuum pipeline to form the foregoing vacuumization apparatus 13, where the specific number of the dry pumps 131 is set according to a furnace pressure requirement.

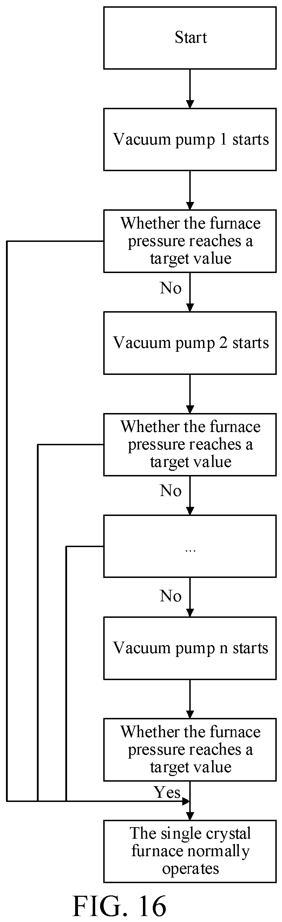

In a specific embodiment, if the number of the plurality of dry pumps 131 is n, a control logic is shown in FIG. 16. When a target furnace pressure is set for the single crystal furnace 20 and an argon flow rate (for example, 60 L/min) is given, a first dry pump 131 is started, and an operating frequency of the dry pump 131 is increased; when a slope of changes of the furnace pressure approaches 0, a next dry pump 131 is started, and an operating frequency of the dry pump 131 is increased; and such a repetition is performed until the furnace pressure reaches a set value. After the furnace pressure reaches the target furnace pressure set by the system, the started dry pumps 131 run normally. In addition, if the furnace pressure of the device fluctuates, the start/stop of the dry pumps 131 also needs to be changed, to stabilize the furnace pressure.

In this embodiment of the present application, the pumping speed of the dry pump 131 may be 300 L/s or 600 L/s. When the pumping speed of the dry pump 131 is 300 L/s, the number of the dry pumps 131 is set to 4. When the pumping speed of the dry pump 131 is 600 L/s, the number of the dry pumps 131 is set to 3.

For example, when the foregoing vacuumization apparatus 13 includes four dry pumps 131 that are disposed in parallel and that have a pumping speed of 300 L/s, a process of pulling a doped single crystal is as follows:

(1) During furnace opening and vacuumization, one or more dry pumps 131 are started, vacuumization is performed to reduce a pressure in the furnace to less than 10 Pa, and leakage detection is performed, to ensure that a leakage rate of the entire crystal pulling system satisfies a requirement.

(2) After the system has passed the leakage detection, the silicon material starts to be added to the furnace, and the melted material is heated. In this process, two groups of dry pumps 131 are started, and an argon flow rate ranging from 1 to 20 L/min is given, to ensure that the gas pressure in the furnace ranges from 50 to 100 Pa.

(3) After the melting of the silicon material is completed, seed crystal is used for performing seed dipping and shouldering. In this process, the one or more dry pumps 131 in the vacuumization apparatus 13 are started, and an argon flow rate ranging from 1 to 20 L/min is given, to ensure that the gas pressure in the furnace ranges from 10 to 100 Pa.

(4) After seed dipping and shouldering are completed, the crystal starts to undergo constant-diameter growth. In this process, three groups of dry pumps 131 are started gradually according to a change of the furnace pressure, and an argon flow rate ranging from 1 to 10 L/min is given, to ensure that the gas pressure in the furnace ranges from 0.5 to 10 Pa at the middle and late stages of constant-diameter growth.

(5) The constant-diameter growth is completed. **In** this process, the other three groups of dry pumps 131 are turned off, and an argon flow rate ranging from 1 to 20 L/min is given, to ensure that the gas pressure in the furnace is greater than 100 Pa. The crystal rod is taken out.

The foregoing processes (2), (3), (4), and (5) are cyclically performed until the furnace shuts down.

Test data of operating limit furnace pressures of the foregoing vacuumization apparatus 13 is shown in Table 5:

Table 5

| argon flow rate (L/min) | 50 |
|---|---|
| Pumping speed (L/s) of a dry pump | 300 |
| Target furnace pressure (mTorr) | 100 |
| Actual furnace pressure (Torr) of starting dry pump 1 | 4 |
| Actual furnace pressure (Torr) of starting dry pump 2 | 1 |
| Actual furnace pressure (Torr) of starting dry pump 3 | 0.4 |
| Actual furnace pressure (mTorr) of starting dry pump 4 | 100 |

In another embodiment, as shown in FIG. 4, the plurality of vacuum pumps include one molecular pump 132 and one dry pump 131, where a front end of the molecular pump 132 is in communication with an air outlet 122 of the filtering apparatus 12 by using the vacuum pipeline, and a tail end of the molecular pump 132 is in communication with a front end of the dry pump 131 by using the vacuum pipeline.

In this embodiment, the foregoing vacuumization apparatus 13 is formed by connecting one molecular pump 132 and one dry pump 131 in series. The molecular pump 132 is used in cooperation with the dry pump 131. After the dry pump 131 reduces the furnace pressure to a performance limit thereof, the molecular pump 132 can be run to further reduce the furnace pressure, for example, to below 1 Pa. A control logic thereof is specifically shown in FIG. 7. After a target furnace pressure is set for the single crystal furnace 20 and an argon flow rate is given, the dry pump 131 is first started to run without flow of argon, and when the furnace pressure reaches a furnace pressure less than 100 mTorr at which the molecular pump 132 starts, the molecular pump 132 is started to run, then argon is input according to the given argon flow rate, and then the furnace pressure is controlled to be in a state of the target furnace pressure by adjusting a rotation rate of the molecular pump 132.

In a specific embodiment, the foregoing filtering apparatus 12 includes a plurality of filtering sub-apparatuses 12 that are disposed in series by using a vacuum pipeline and that are configured to filter dust. In this specific embodiment, considering that a working environment required by the molecular pump 132 is clearer than that required by the dry pump 131, the filtering apparatus 12 is formed by connecting a plurality of stages of filtering sub-apparatuses 12 in series by using a vacuum pipeline, so as to more thoroughly clean and filter the gas that is pumped into the molecular pump 132, thereby protecting the molecular pump 132 and prolonging its service life. The plurality of stages of filtering sub-apparatuses 12 may be specifically 2 stages.

In this embodiment of the present application, the foregoing filtering apparatus 12 may be specifically a filtration tank, and a filtering bag of the filtration tank has a hole diameter of less than 0.5 $\mu$m, so that a particle size of dust in the gas that is filtered by the filtering apparatus 12 is less than 0.5 $\mu$m, thereby satisfying a working requirement of the molecular pump 132.

In the single crystal furnace vacuum system 10 provided in this embodiment of the present application, starting from the working principle of the vacuum pump, the plurality of vacuum pumps are connected in series or in parallel by using the vacuum pipeline to form the vacuumization apparatus 13, so that vacuumization performance of the vacuumization apparatus 13 can be improved without changing performance of the vacuum pump, to achieve a low furnace pressure effect. Then, during Czochralski crystal growth, an operating state of the vacuumization apparatus 13 is adjusted, so that a furnace pressure of the single crystal furnace 20 gradually decreases with constant-diameter growth, and a monocrystalline silicon rod whose axial resistivity tends to be uniform can be obtained.

For example, when the foregoing vacuumization apparatus 13 includes 3 dry pumps 131 that are disposed in parallel and that have a pumping speed of 600 L/s, a process of pulling single crystal in a 26-inch thermal field is as follows:

(1) During furnace opening and vacuumization, one or more dry pumps are started, vacuumization is performed to reduce a pressure in the furnace to less than 10 Pa, and leakage detection is performed, to ensure that a leakage rate of the entire crystal pulling system satisfies a requirement.

(2) After the system has passed the leakage detection, the silicon material starts to be added to the furnace, and the melted material is heated. In this process, two groups of dry pumps are started, and an argon flow rate ranging from 1 to 20 L/min is given, to ensure that the gas pressure in the furnace ranges from 50 to 100 Pa.

(3) After the melting of the silicon material is completed, seed crystal is used for performing seed dipping and shouldering. In this process, the one or more dry pumps in the vacuumization apparatus are started, and an argon flow rate ranging from 1 to 20 L/min is given, to ensure that the gas pressure in the furnace ranges from 10 to 100 Pa.

(4) After seed dipping and shouldering are completed, the crystal starts to undergo constant-diameter growth, to obtain doped monocrystalline silicon. In this process, operating states of three groups of dry pumps are started gradually according to the following Table 6 and according to a change of the furnace pressure, and an argon flow rate ranging from 1 to 10 L/min is given, to ensure that the gas pressure in the furnace ranges from 0.5 to 10 Pa at the middle and late stages of constant-diameter growth.

(5) The constant-diameter growth is completed. In this process, the other three groups of dry pumps are turned off, and an argon flow rate ranging from 1 to 20 L/min is given, to ensure that the gas pressure in the furnace is greater than 100 Pa. The crystal rod is taken out.

The foregoing steps (2), (3), (4), and (5) are cyclically performed until the furnace shuts down.

Experimental data shows that by using the foregoing low-furnace-pressure crystal pulling process, the length of the pulled crystal rod is increased by more than 20%, and the effect of alleviating the problem of resistivity attenuation of the crystal rod is good.

Table 6

| Constant-diameter length percent | Furnace pressure (Pa) | argon flow rate (splm) | Opening degree of a throttle valve | Frequency (Hz) of dry pump 1 | Frequency (Hz) of dry pump 2 | Frequency (Hz) of dry pump 3 |
|---|---|---|---|---|---|---|
| 1% | 500 | 60 | 25% | 20 | 0 | 0 |
| 4% | 250 | 45 | 41% | 40 | 0 | 0 |
| 7% | 100 | 35 | 58% | 60 | 15 | 0 |
| 10% | 60 | 18 | 75% | 60 | 45 | 0 |
| 17% | 10 | 8 | 90% | 60 | 60 | 18 |
| 35% | 1 | 3 | 100% | 60 | 60 | 35 |
| 63% | 0.7 | 1 | 100% | 60 | 60 | 60 |
| 85% | 0.7 | 1 | 100% | 60 | 60 | 60 |
| 100% | 0.7 | 1 | 100% | 60 | 60 | 60 |

For example, when the foregoing vacuumization apparatus includes a molecular pump and a dry pump that are disposed in series, a process of pulling a single crystal is as follows:

(1) During furnace opening and vacuumization, the dry pump is started, vacuumization is performed to reduce a pressure in the furnace to less than 10 Pa, and leakage detection is performed, to ensure that a leakage rate of the entire crystal pulling system satisfies a requirement.

(2) After the system has passed the leakage detection, the silicon material starts to be added to the furnace, and the melted material is heated. In this process, the dry pump and the molecular pump are started, and an argon flow rate ranging from 1 to 20 L/min is given, to ensure that the gas pressure in the furnace ranges from 50 to 100 Pa.

(3) After the melting of the silicon material is completed, seed crystal is used for performing seed dipping and shouldering. In this process, the dry pump and the molecular pump in the vacuumization apparatus are started, and an argon flow rate ranging from 1 to 20 L/min is given, to ensure that the gas pressure in the furnace ranges from 10 to 100 Pa.

(4) After seed dipping and shouldering are completed, the crystal starts to undergo constant-diameter growth, to obtain doped monocrystalline silicon. In this process, operating states of the dry pump and the molecular pump are adjusted according to the following Table 7 and according to a change of the furnace pressure, and an argon flow rate ranging from 1 to 10 L/min is given, to ensure that the gas pressure in the furnace ranges from 0.5 to 10 Pa at the middle and late stages of constant-diameter growth.

(5) The constant-diameter growth is completed. In this process, the molecular pump is turned off, only the dry pump is started, and an argon flow rate ranging from 1 to 20 L/min is given, to ensure that the gas pressure in the furnace is greater than 100 Pa. The crystal rod is taken out.

The foregoing steps (2), (3), (4), and (5) are cyclically performed until the furnace shuts down.

Table 7

| Constant-diameter length percent | Furnace pressure (Pa) | argon flow rate (splm) | Rotation rate (r/min) of the molecular pump | Dry pump frequency (Hz) |
|---|---|---|---|---|
| 1% | 100 | 15 | 0 | 35 |
| 4% | 50 | 5 | 0 | 35 |
| 7% | 30 | 3 | 3000 | 40 |
| 10% | 10 | 1 | 6000 | 40 |
| 17% | 5 | 1 | 8000 | 45 |
| 45% | 1 | 1 | 10000 | 50 |
| 73% | 0.7 | 1 | 13600 | 54 |
| 85% | 0.7 | 1 | 13600 | 54 |
| 100% | 0.7 | 1 | 13600 | 54 |

In addition, the present application further provides a Czochralski crystal growth device, including a single crystal furnace and the single crystal furnace vacuum system described above.

The foregoing embodiment of the single crystal furnace includes the foregoing single crystal furnace vacuum system 10, and can achieve the same technical effect. To avoid repetition, details are not described herein again, and reference may be made to the descriptions of the embodiment of the single crystal furnace vacuum system 10 for the associated part.

In conclusion, in this embodiment, the single crystal furnace vacuum system in the present application includes an exhaust pipe group, a filtering apparatus, and a vacuumization apparatus, where one end of the exhaust pipe group is in communication with a furnace bottom of a single crystal furnace; the other end of the exhaust pipe group is in communication with an air inlet of the filtering apparatus; the vacuumization apparatus is in communication with an air outlet of the filtering apparatus by using a vacuum pipeline; and the vacuumization apparatus includes a plurality of vacuum pumps, and the plurality of vacuum pumps are connected in series or in parallel by using the vacuum pipeline. The plurality of vacuum pumps are connected in series or in parallel by using the vacuum pipeline to form the vacuumization apparatus, so that vacuumization performance of the vacuumization apparatus can be improved without changing performance of the vacuum pump, to achieve a low furnace pressure effect, thereby effectively reducing a resistivity attenuation rate of the crystal rod.

It should be understood that orientation or position relationships indicated by the terms involved above such as "center", "longitudinal", "transverse", "above", "below", "front", "back", "left", "right", "vertical", "horizontal" "top", "bottom", "inside", and "outside" are based on orientation or position relationships shown in the accompanying drawings, and are used only for ease and brevity of illustration and description of the present application, rather than indicating or implying that the mentioned apparatus or component needs to have a particular orientation or needs to be constructed and operated in a particular orientation. Therefore, such terms should not be construed as limiting of the present application. In addition, the terms "first" and "second" are used for descriptive objectives only and are not to be construed as indicating or implying relative importance or implicitly indicating the number of technical features indicated. Therefore, a feature defined by "first" or "second" may explicitly indicate or implicitly include one or more features. In the description of the present application, unless otherwise stated, "a plurality of" means two or more than two.

The foregoing descriptions are merely preferred embodiments of the present application and descriptions of the technical principles used. A person skilled in the art should understand that the scope of the present application is not limited to the technical solutions that are formed by the foregoing particular combinations of technical features, but shall also encompass other technical solutions formed by arbitrarily combining the foregoing technical features or equivalent features thereof without departing from the foregoing inventive concept. For example, technical solutions formed by replacing the foregoing features with technical features having similar functions disclosed in the present application (but not limited thereto) are also included.

**Claims**

1. A crystal growth method, comprising:

   performing leakage detection on a single crystal furnace in an environment at a first furnace pressure;
   adding a dopant into the single crystal furnace in an environment at a second furnace pressure, wherein the second furnace pressure is greater than the first furnace pressure; and
   performing a crystal pulling process after the dopant is added.

2. The crystal growth method according to claim 1, wherein the first furnace pressure is less than 1 Torr.

3. The crystal growth method according to claim 1, wherein the second furnace pressure is greater than 60 Torr.

4. The crystal growth method according to claim 2, wherein the adding a dopant into the single crystal furnace in an environment at a second furnace pressure comprises:

   adding a silicon material and the dopant into the single crystal furnace in the environment at the second furnace pressure;
   or adding a silicon material into the single crystal furnace in the environment at the first furnace pressure; and
   adding the dopant into the single crystal furnace in the environment at the second furnace pressure after the silicon material is melted.

5. The crystal growth method according to claim 1, wherein the performing a crystal pulling process comprises:
   performing constant-diameter growth after shoulder formation, and performing Czochralski crystal growth by lowering a crystal pulling furnace pressure from the second furnace pressure at a constant-diameter growth stage according to an actual constant-diameter growth length of doped monocrystalline silicon.

6. The crystal growth method according to claim 5, wherein the performing Czochralski crystal growth by lowering a crystal pulling furnace pressure from the second furnace pressure at a constant-diameter growth stage according to an actual constant-diameter growth length of doped monocrystalline silicon comprises:
   controlling a crystal pulling furnace pressure at an initial phase of constant-diameter growth to be within a range of 80 to 300 Torr; and controlling a crystal pulling furnace pressure at a final phase of constant-diameter growth to be less than 100 mTorr.

7. The crystal growth method according to claim 6, wherein an argon flow rate at the initial phase of constant-diameter growth is greater than 200 L/min; and an argon flow rate at the final phase of the constant-diameter growth is less than 5 L/min.

8. The crystal growth method according to claim 5, wherein before the performing Czochralski crystal growth by lowering a crystal pulling furnace pressure from the second furnace pressure at a constant-diameter growth stage according to an actual constant-diameter growth length of doped monocrystalline silicon, the method further comprises:
   determining a first correspondence between crystal pulling furnace pressures and constant-diameter growth lengths of the doped monocrystalline silicon, wherein in the first correspondence, crystal pulling furnace pressures corresponding to different constant-diameter growth lengths are at least partially different, to cause an axial concentration of a doping element in the doped monocrystalline silicon to tend to be uniform in response to controlling Czochralski crystal growth at the constant-diameter growth stage at a crystal pulling furnace pressure determined according to the first correspondence; and the performing Czochralski crystal growth by lowering a crystal pulling furnace pressure from the second furnace pressure at a constant-diameter growth stage according to an actual constant-diameter growth length of doped monocrystalline silicon comprises:

   obtaining the actual constant-diameter growth length of the doped monocrystalline silicon when the doped monocrystalline silicon is at the constant-diameter growth stage;
   determining a target crystal pulling furnace pressure corresponding to the actual constant-diameter growth length according to the first correspondence between crystal pulling furnace pressures and constant-diameter growth lengths of the doped monocrystalline silicon; and
   controlling Czochralski crystal growth according to the target crystal pulling furnace pressure.

9. The crystal growth method according to claim 8, wherein in the first correspondence, crystal pulling furnace pressures and constant-diameter growth lengths of the doped monocrystalline silicon are negatively correlated.

10. The crystal growth method according to claim 8, wherein the controlling Czochralski crystal growth according to the target crystal pulling furnace pressure comprises:
adjusting crystal pulling process parameters according to the target crystal pulling furnace pressure, wherein the crystal pulling process parameters comprise an argon flow rate and a dry pump frequency.

11. The crystal growth method according to claim 10, wherein before the adjusting crystal pulling process parameters according to the target crystal pulling furnace pressure, the method further comprises:
determining a second correspondence among crystal pulling furnace pressures of the doped monocrystalline silicon, argon flow rates, and dry pump frequencies, wherein in response to controlling Czochralski crystal growth according to an argon flow rate and a dry pump frequency that are determined according to the second correspondence, a crystal pulling furnace pressure of the doped monocrystalline silicon is adjusted to a corresponding pressure value, and a crystal pulling rate of the doped monocrystalline silicon tends to be a maximum value; and the adjusting crystal pulling process parameters according to the target crystal pulling furnace pressure comprises:
determining a target argon flow rate and a target dry pump frequency that correspond to the target crystal pulling furnace pressure according to the second correspondence among crystal pulling furnace pressures of the doped monocrystalline silicon, argon flow rates, and dry pump frequencies; and controlling Czochralski crystal growth according to the target argon flow rate and the target dry pump frequency.

12. The crystal growth method according to claim 10, wherein the crystal pulling process parameters further comprise a heater power and a crystal pulling rate;
before the adjusting crystal pulling process parameters according to the target crystal pulling furnace pressure, the method further comprises:
determining a third correspondence among crystal pulling furnace pressures of the doped monocrystalline silicon, argon flow rates, dry pump frequencies, heater powers, and crystal pulling rates, wherein in response to controlling Czochralski crystal growth according to an argon flow rate a dry pump frequency, a heater power, and a crystal pulling rate that are determined according to the third correspondence, a crystal pulling furnace pressure of the doped monocrystalline silicon is adjusted to a corresponding pressure value, and a crystal pulling rate of the doped monocrystalline silicon tends to be a maximum value; and the adjusting crystal pulling process parameters according to the target crystal pulling furnace pressure comprises:
determining a target argon flow rate, a target dry pump frequency, a target heater power, and a target crystal pulling rate that correspond to the target crystal pulling furnace pressure according to the third correspondence among crystal pulling furnace pressures of the doped monocrystalline silicon, argon flow rates, dry pump frequencies, heater powers, and crystal pulling rates; and controlling Czochralski crystal growth according to the target argon flow rate, the target dry pump frequency, the target heater power, and the target crystal pulling rate.

13. The crystal growth method according to claim 10, wherein in the second correspondence, the crystal pulling furnace pressures are positively correlated with the argon flow rates.

14. The crystal growth method according to claim 1, wherein the performing a crystal pulling process comprises:

performing a temperature adjustment operation at a third furnace pressure after completing dopant addition and melting a silicon material, wherein the third furnace pressure is less than or equal to 5 Torr;
performing operations of seed dipping, shouldering, and shoulder formation at a fourth furnace pressure after temperature adjustment, wherein the fourth furnace pressure is less than or equal to the third furnace pressure; and
performing constant-diameter growth after shoulder formation, and performing Czochralski crystal growth by lowering a crystal pulling furnace pressure from the fourth furnace pressure at a constant-diameter growth stage according to an actual constant-diameter growth length of doped monocrystalline silicon.

15. A crystal growth method, comprising:

performing temperature adjustment at a fifth furnace pressure after a silicon material is melted, wherein the fifth furnace pressure is less than or equal to 3 Torr;
performing seed dipping, shouldering, and shoulder formation at a sixth furnace pressure after temperature adjustment, wherein the sixth furnace pressure is less than or equal to the fifth furnace pressure; and
performing constant-diameter growth after shoulder formation, and performing Czochralski crystal growth by lowering a crystal pulling furnace pressure from the sixth furnace pressure at a constant-diameter growth stage according to an actual constant-diameter growth length.

16. The crystal growth method according to claim 15, wherein the performing Czochralski crystal growth by lowering a crystal pulling furnace pressure from the sixth furnace pressure according to an actual constant-diameter growth length of monocrystalline silicon comprises:
controlling a crystal pulling furnace pressure at the constant-diameter growth stage to be within a range of 1 mTorr to 3 Torr, an argon flow rate to be within a range of 5 to 200 L/min, and a dry pump frequency to be within a range of 30 to 55 Hz.

17. The crystal growth method according to claim 15, wherein the performing Czochralski crystal growth by lowering a crystal pulling furnace pressure from the sixth furnace pressure according to an actual constant-diameter growth length of monocrystalline silicon comprises:
controlling a crystal rotation rate to be within a range of 5 to 11 RPM and a crucible rotation rate to be within a range of 4 to 9 RPM.

18. The crystal growth method according to claim 15, wherein the performing Czochralski crystal growth by lowering a crystal pulling furnace pressure from the sixth furnace pressure according to an actual constant-diameter growth length comprises:
controlling, in response to increasing the actual constant-diameter growth length from zero to less than or equal to 5% of a total length of a constant-diameter part, a furnace pressure to be within a range of 0.3 to 3 Torr, an argon flow rate to be within a range of 15 L/min to 50 L/min, and a heating power to decrease by 2.5 Kw.

19. The crystal growth method according to claim 15, wherein the performing Czochralski crystal growth by lowering a crystal pulling furnace pressure from the sixth furnace pressure according to an actual constant-diameter growth length comprises: controlling a pulling rate to be within a range of 75 mm/hr to 120 mm/hr and a crucible rotation rate to be within a range of 5 RPM to 6 RPM.

20. The crystal growth method according to claim 19, wherein the performing Czochralski crystal growth by lowering a crystal pulling furnace pressure from the sixth furnace pressure according to an actual constant-diameter growth length further comprises:
controlling, in response to increasing the actual constant-diameter growth length from 5% of a total length of a constant-diameter part to less than or equal to 10% of the total length of the constant-diameter part, a furnace pressure to be within a range of 5 mTorr to 0.3 Torr and an argon flow rate to be within a range of 5 L/min to 15 L/min.

21. The crystal growth method according to claim 15, wherein the performing Czochralski crystal growth by lowering a crystal pulling furnace pressure from the sixth furnace pressure according to an actual constant-diameter growth length comprises:
controlling, in response to increasing the actual constant-diameter growth length from 10% of a total length of a constant-diameter part to less than or equal to 55% of the total length of the constant-diameter part, a furnace pressure to be not greater than 5 mTorr and an argon flow rate to be not less than 5 L/min.

22. The crystal growth method according to claim 15, wherein the performing Czochralski crystal growth by lowering a crystal pulling furnace pressure from the sixth furnace pressure according to an actual constant-diameter growth length comprises:
controlling, in response to increasing the actual constant-diameter growth length from 55% of a total length of a constant-diameter part to less than or equal to 100% of the total length of the constant-diameter part, a furnace pressure to be within a range of 1 mTorr to 5 mTorr, an argon flow rate to be 5 L/min, and a dry pump frequency to be 55 Hz.

23. The crystal growth method according to any one of claims 20 to 22, wherein during the performing Czochralski crystal growth by lowering a crystal pulling furnace pressure from the sixth furnace pressure, a pulling rate increment $\Delta V$ and a power increment $\Delta P$ satisfy $\Delta V = -K * \Delta P$, wherein K ranges from 0.06 to 0.11.

24. The crystal growth method according to claim 15, wherein a furnace pressure P of a single crystal furnace, a dry pump quantity n, a dry pump frequency f, and an argon flow rate Q satisfy the following relational expression:

$$P=A/(n * f) - B/Q + C$$

wherein A ranges from 1 to 120, B ranges from 1 to 100, C ranges from 0 to 0.05, and $Q \geq 1$ L/min.

25. Crystalline silicon, prepared by using the crystal growth method according to any one of claims 1 to 24.

26. The crystalline silicon according to claim 25, wherein an oxygen content of the crystalline silicon is less than or equal to 11 ppma.

27. A single crystal furnace vacuum system, comprising an exhaust pipe group, a filtering apparatus, and a vacuumization apparatus, wherein

one end of the exhaust pipe group is in communication with a furnace bottom of a single crystal furnace;
the other end of the exhaust pipe group is in communication with an air inlet of the filtering apparatus;
the vacuumization apparatus is in communication with an air outlet of the filtering apparatus by using a vacuum pipeline; and
the vacuumization apparatus comprises a plurality of vacuum pumps, and the plurality of vacuum pumps are connected in series or in parallel by using the vacuum pipeline.

28. The single crystal furnace vacuum system according to claim 27, wherein the plurality of vacuum pumps comprise a plurality of dry pumps, and the plurality of dry pumps are connected in parallel by using the vacuum pipeline.

29. The single crystal furnace vacuum system according to claim 27, wherein the plurality of vacuum pumps comprise one molecular pump and one dry pump, and a front end of the molecular pump is in communication with an air outlet of the filtering apparatus by using the vacuum pipeline; and a tail end of the molecular pump is in communication with a front end of the dry pump by using the vacuum pipeline.

30. The single crystal furnace vacuum system according to claim 27, wherein the furnace bottom of the single crystal furnace is provided with an exhaust vent, and the exhaust vent is connected to the other end of the exhaust pipe group.

31. The single crystal furnace vacuum system according to claim 30, wherein at least two exhaust vents are provided, and a ratio of a total area of the exhaust vents to a total area of the furnace bottom is less than 50%.

32. The single crystal furnace vacuum system according to claim 31, wherein the exhaust vents are uniformly distributed along the furnace bottom.

33. The single crystal furnace vacuum system according to any one of claims 30 to 32, wherein the exhaust vent is circular or square.

34. The single crystal furnace vacuum system according to claim 31, wherein the exhaust pipe group comprises a plurality of exhaust pipelines disposed in parallel, and a front end of each of the exhaust pipelines is connected to one of the exhaust vents.

35. The single crystal furnace vacuum system according to claim 34, wherein a first throttle valve is disposed on the exhaust pipeline between the exhaust vent and the filtering apparatus.

36. The single crystal furnace vacuum system according to claim 34, wherein the exhaust pipe group further comprises a convergence pipeline, tail ends of at least two of the exhaust pipelines are connected to one end of the convergence pipeline, and the other end of the convergence pipeline is connected to the air inlet of the filtering apparatus by using a vacuum ball valve.

37. The single crystal furnace vacuum system according to claim 36, wherein a cross-sectional flow area of the convergence pipeline is greater than a cross-sectional flow area of each of the exhaust pipelines connected to the convergence pipeline.

38. The single crystal furnace vacuum system according to claim 36, wherein a cross-sectional flow area of the convergence pipeline is not less than a sum of cross-sectional flow areas of the exhaust pipelines connected to the convergence pipeline.

39. The single crystal furnace vacuum system according to claim 36, wherein a second throttle valve is disposed on the convergence pipeline.

40. The single crystal furnace vacuum system according to claim 27, wherein the single crystal furnace vacuum system is configured to control, in a case that a given argon flow rate ranges from 1 to 10 L/min in the single crystal furnace, a gas pressure in the furnace to be within a range of 0.5 to 10 Pa.

41. A Czochralski crystal growth device, comprising a single crystal furnace and the single crystal furnace vacuum system according to any one of claims 27 to 40.

```
┌────────────────────────────────────────────────────────────────────┐
│  Perform leakage detection on a single crystal furnace in an         │    101
│  environment at a first furnace pressure                             │
└────────────────────────────────────────────────────────────────────┘
                                    │
┌────────────────────────────────────────────────────────────────────┐
│  Add a dopant into the single crystal furnace in an environment at a │    102
│  second furnace pressure, where the second furnace pressure is       │
│  greater than the first furnace pressure                             │
└────────────────────────────────────────────────────────────────────┘
                                    │
┌────────────────────────────────────────────────────────────────────┐
│  Perform a crystal pulling process after the dopant is added         │    103
└────────────────────────────────────────────────────────────────────┘
```

## FIG. 1

```
┌────────────────────────────────────────────────────────────────────┐
│  Perform leakage detection on a single crystal furnace in an         │    201
│  environment at a first furnace pressure                             │
└────────────────────────────────────────────────────────────────────┘
                                    │
                                    ▼
┌────────────────────────────────────────────────────────────────────┐
│  Add a dopant into the single crystal furnace in an environment at a │    202
│  second furnace pressure, where the first furnace pressure is less   │
│  than the second furnace pressure                                    │
└────────────────────────────────────────────────────────────────────┘
                                    │
                                    ▼
┌────────────────────────────────────────────────────────────────────┐
│  Perform constant-diameter growth after shoulder formation, and      │    203
│  perform Czochralski crystal growth by lowering a crystal pulling    │
│  furnace pressure from the second furnace pressure at an             │
│  constant-diameter growth stage according to an actual               │
│  constant-diameter growth length of doped monocrystalline silicon    │
└────────────────────────────────────────────────────────────────────┘
```

## FIG. 2

Determine a first correspondence between crystal pulling furnace pressures and constant-diameter growth lengths of the doped monocrystalline silicon, where in the first correspondence, crystal pulling furnace pressures corresponding to different constant-diameter growth lengths are at least partially different, to cause an axial concentration of a doping element in the doped monocrystalline silicon to tend to be uniform in response to controlling Czochralski crystal growth at the constant-diameter growth stage at a crystal pulling furnace pressure determined according to the first correspondence 〜 301

Perform leakage detection on a single crystal furnace in an environment at a first furnace pressure 〜 302

Add a dopant into the single crystal furnace in an environment at a second furnace pressure, where the first furnace pressure is less than the second furnace pressure 〜 303

Perform constant-diameter growth after shoulder formation, and obtain the actual constant-diameter growth length of the doped monocrystalline silicon when the doped monocrystalline silicon is at the constant-diameter growth stage 〜 304

Determine a target crystal pulling furnace pressure corresponding to the actual constant-diameter growth length according to the first correspondence between crystal pulling furnace pressures and constant-diameter growth lengths of the doped monocrystalline silicon 〜 305

Control Czochralski crystal growth according to the target crystal pulling furnace pressure 〜 306

FIG. 3

Perform leakage detection on a single crystal furnace in an environment at a first furnace pressure — 401

Add a dopant into the single crystal furnace in an environment at a second furnace pressure, where the first furnace pressure is less than the second furnace pressure — 402

Perform a temperature adjustment operation at a third furnace pressure after completing dopant addition and melting a silicon material, where the third furnace pressure is less than or equal to 5 Torr — 403

Perform operations of seed dipping, shouldering, and shoulder formation at a fourth furnace pressure after temperature adjustment, where the fourth furnace pressure is less than or equal to the third furnace pressure — 404

Perform constant-diameter growth after shoulder formation, and perform Czochralski crystal growth by lowering a crystal pulling furnace pressure from the fourth furnace pressure at an constant-diameter growth stage according to an actual constant-diameter growth length of doped monocrystalline silicon — 405

## FIG. 4

Pulling rate comparison statistics (mm/h)

113

108

A                    B

## FIG. 5

Head resistance hit ratio comparison statistics

| | |
|---|---|
| 94% | |
| 92% | 92% |
| 90% | |
| 88% | |
| 86% | |
| 84% | 85% |
| 82% | |
| 80% | |
| | A        B |

## FIG. 6

Perform temperature adjustment at a first furnace pressure after a silicon material is melted, where the first furnace pressure is less than or equal to 3 Torr — 701

Perform operations of seed dipping, shouldering, and shoulder formation at a second furnace pressure after temperature adjustment, where the second furnace pressure is less than or equal to the first furnace pressure — 702

Perform constant-diameter growth after shoulder formation, and perform Czochralski crystal growth by lowering a crystal pulling furnace pressure from the second furnace pressure at an constant-diameter growth stage according to an actual constant-diameter growth length of doped monocrystalline silicon — 703

## FIG. 7

| Determine a first correspondence between crystal pulling furnace pressures and constant-diameter growth length ranges of the doped monocrystalline silicon, where in the first correspondence, crystal pulling furnace pressures corresponding to different constant-diameter growth length ranges are at least partially different, to cause an axial concentration of a doping element in the doped monocrystalline silicon to tend to be uniform in response to controlling Czochralski crystal growth at the constant-diameter growth stage at a crystal pulling furnace pressure determined according to the first correspondence | 801 |

↓

| Perform a temperature adjustment operation at a first furnace pressure after melting is completed, where the first furnace pressure is less than or equal to 3 Torr | 802 |

↓

| Perform operations of seed dipping, shouldering, and shoulder formation at a second furnace pressure after temperature adjustment, where the second furnace pressure is less than or equal to the first furnace pressure | 803 |

↓

| Perform constant-diameter growth after shoulder formation, and obtain the actual constant-diameter growth length of the doped monocrystalline silicon when the doped monocrystalline silicon is at the constant-diameter growth stage | 804 |

↓

| Determine a target constant-diameter growth length range to which the actual constant-diameter growth length belongs | 805 |

↓

| Determine a target crystal pulling furnace pressure corresponding to the actual constant-diameter growth length according to the first correspondence between crystal pulling furnace pressures and constant-diameter growth length ranges of the doped monocrystalline silicon | 806 |

↓

| Control Czochralski crystal growth according to the target crystal pulling furnace pressure | 807 |

## FIG. 8

## FIG. 9

FIG. 10

FIG. 11

FIG. 12

FIG. 13

FIG. 14

FIG. 15

```
          ┌─────────────────┐
          │      Start      │
          └────────┬────────┘
                   ▼
          ┌─────────────────┐
          │ Vacuum pump 1   │
          │     starts      │
          └────────┬────────┘
                   ▼
          ┌─────────────────┐
          │ Whether the     │
          │ furnace pressure│
          │ reaches a       │
          │ target value    │
          └────────┬────────┘
                 No│
                   ▼
          ┌─────────────────┐
          │ Vacuum pump 2   │
          │     starts      │
          └────────┬────────┘
                   ▼
          ┌─────────────────┐
          │ Whether the     │
          │ furnace pressure│
          │ reaches a       │
          │ target value    │
          └────────┬────────┘
                 No│
                   ▼
          ┌─────────────────┐
          │       ...       │
          └────────┬────────┘
                 No│
                   ▼
          ┌─────────────────┐
          │ Vacuum pump n   │
          │     starts      │
          └────────┬────────┘
                   ▼
          ┌─────────────────┐
          │ Whether the     │
          │ furnace pressure│
          │ reaches a       │
          │ target value    │
          └────────┬────────┘
                Yes│
                   ▼
          ┌─────────────────┐
          │ The single      │
          │ crystal furnace │
          │ normally        │
          │ operates        │
          └─────────────────┘
```

FIG. 16

FIG. 17

## INTERNATIONAL SEARCH REPORT

| International application No. |
|---|
| **PCT/CN2023/132728** |

### A. CLASSIFICATION OF SUBJECT MATTER

C30B15/04(2006.01)i;  C30B15/20(2006.01)i;  C30B29/06(2006.01)i;  F04B41/06(2006.01)i

According to International Patent Classification (IPC) or to both national classification and IPC

### B. FIELDS SEARCHED

Minimum documentation searched (classification system followed by classification symbols)

IPC：C30B,F04B

Documentation searched other than minimum documentation to the extent that such documents are included in the fields searched

Electronic data base consulted during the international search (name of data base and, where practicable, search terms used)

VEN; CNTXT; CNABS; CNKI; Web of Science: 单晶, 硅, 掺杂, 炉压, 氩气, 干泵, 真空, 直拉, crystal, silicon, furnace pressure, dope, Ar, pump, vacuum, pulling

### C. DOCUMENTS CONSIDERED TO BE RELEVANT

| Category* | Citation of document, with indication, where appropriate, of the relevant passages | Relevant to claim No. |
|---|---|---|
| PX | CN 115874270 A (LONGJI GREEN ENERGY TECHNOLOGY CO., LTD.) 31 March 2023 (2023-03-31) description, paragraphs [0005]-[0191] | 1-14, 25 |
| PX | CN 115976628 A (LONGJI GREEN ENERGY TECHNOLOGY CO., LTD.) 18 April 2023 (2023-04-18) description, paragraphs [0005]-[0181] | 15-25 |
| Y | CN 104831346 A (TIANJIN HUAN-OU SEMICONDUCTOR MATERIAL TECHNOLOGY CO., LTD.) 12 August 2015 (2015-08-12) description, paragraph [0026] | 1-5 |
| Y | CN 115074827 A (WUHAI JINGYUNTONG NEW MATERIAL TECHNOLOGY CO., LTD.) 20 September 2022 (2022-09-20) description, paragraphs [0015] and [0016] | 1-5 |
| X | WO 2022148402 A1 (LONGJI GREEN ENERGY TECHNOLOGY CO., LTD.) 14 July 2022 (2022-07-14) description, page 20, paragraph 2-page 23, paragraph 2 | 25 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **01 February 2024** | **23 February 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**EP 4 624 638 A1**

## INTERNATIONAL SEARCH REPORT

| | International application No. |
|---|---|
| | **PCT/CN2023/132728** |

| C. | DOCUMENTS CONSIDERED TO BE RELEVANT | |
|---|---|---|
| Category* | Citation of document, with indication, where appropriate, of the relevant passages | Relevant to claim No. |
| Y | WO 2022148402 A1 (LONGJI GREEN ENERGY TECHNOLOGY CO., LTD.) 14 July 2022 (2022-07-14)<br>   description, page 20, paragraph 2-page 23, paragraph 2 | 5 |
| X | CN 207143364 U (QINGHAI XINNUO OPTOELECTRONICS TECHNOLOGY CO., LTD.) 27 March 2018 (2018-03-27)<br>   description, paragraphs [0006]-[0011] | 27-28, 30-41 |
| Y | CN 207143364 U (QINGHAI XINNUO OPTOELECTRONICS TECHNOLOGY CO., LTD.) 27 March 2018 (2018-03-27)<br>   description, paragraphs [0006]-[0011] | 29 |
| Y | CN 207313743 U (SHANGHAI YUGUANG NEW MATERIAL TECHNOLOGY CO., LTD.) 04 May 2018 (2018-05-04)<br>   description, paragraphs [0025]-[0036] | 29 |
| A | CN 113652737 A (LONGJI GREEN ENERGY TECHNOLOGY CO., LTD.) 16 November 2021 (2021-11-16)<br>   description, paragraphs [0005]-[0224] | 1-41 |
| A | CN 112981520 A (LONGJI GREEN ENERGY TECHNOLOGY CO., LTD.) 18 June 2021 (2021-06-18)<br>   description, paragraphs [0005]-[0141] | 1-41 |
| A | CN 111424313 A (BAOTOU MEIKE SILICON ENERGY CO., LTD. et al.) 17 July 2020 (2020-07-17)<br>   description, paragraphs [0003]-[0029] | 1-41 |

Form PCT/ISA/210 (second sheet) (July 2022)

## INTERNATIONAL SEARCH REPORT
### Information on patent family members

| International application No. |
| --- |
| **PCT/CN2023/132728** |

| Patent document cited in search report | | | Publication date (day/month/year) | Patent family member(s) | | | Publication date (day/month/year) |
| --- | --- | --- | --- | --- | --- | --- | --- |
| CN | 115874270 | A | 31 March 2023 | None | | | |
| CN | 115976628 | A | 18 April 2023 | None | | | |
| CN | 104831346 | A | 12 August 2015 | None | | | |
| CN | 115074827 | A | 20 September 2022 | None | | | |
| WO | 2022148402 | A1 | 14 July 2022 | AU | 2022205729 | A1 | 20 July 2023 |
| | | | | EP | 4257734 | A1 | 11 October 2023 |
| CN | 207143364 | U | 27 March 2018 | None | | | |
| CN | 207313743 | U | 04 May 2018 | None | | | |
| CN | 113652737 | A | 16 November 2021 | None | | | |
| CN | 112981520 | A | 18 June 2021 | None | | | |
| CN | 111424313 | A | 17 July 2020 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211554712
- CN 202211561051
- CN 202223271147
- CN 202320847320